# EUROPEAN PATENT SPECIFICATION

(11) **EP 4 513 265 B1**
(45) Date of publication and mention of the grant of the patent: **02.09.2026**
(21) Application number: 22963816.8
(22) Date of filing: 01.11.2022
(51) Int. Cl.: G02F 1/1345, G06F 3/044, G06F 3/041, B60K 35/22, H10D 86/40, H10D 86/60, B60K 35/10

(54) **ARRAY SUBSTRATE, TOUCH DISPLAY PANEL, DISPLAY APPARATUS, AND VEHICLE-MOUNTED DISPLAY SCREEN**
ARRAYSUBSTRAT, BERÜHRUNGSANZEIGETAFEL, ANZEIGEVORRICHTUNG UND FAHRZEUGMONTIERTER ANZEIGEBILDSCHIRM
SUBSTRAT DE RÉSEAU, ÉCRAN D'AFFICHAGE TACTILE, APPAREIL D'AFFICHAGE ET ÉCRAN D'AFFICHAGE MONTÉ SUR VÉHICULE

(43) Date of publication of application: 26.02.2025
(73) Proprietor: Boe Technology Group Co., Ltd., Beijing 100015 (CN); Chengdu BOE Optoelectronics Technology Co., Ltd., Chengdu, Sichuan 611731 (CN)
(72) Inventor: ZHANG, Yadong, Beijing 100176 (CN); LI, Ting, Beijing 100176 (CN); ZANG, Pengcheng, Beijing 100176 (CN); WU, Bo, Beijing 100176 (CN)
(74) Representative: Potter Clarkson
(86) International application number: PCT/CN2022/128932
(87) International publication number: WO 2024/092497

(56) References cited:
- CN-A- 106 775 124
- CN-A- 114 509 886
- CN-U- 206 470 722
- US-A1- 2014 182 894
- US-A1- 2017 185 190
- US-B2- 10 775 661

## Description

### TECHNICAL FIELD

The present disclosure relates to a field of a display technology, and in particular, to an array substrate, a touch display panel, a display device, and a vehicle-mounted display screen.

### BACKGROUND

Due to a series of advantages such as thinness, low energy consumption, a small size, etc., a liquid crystal display screen has been widely used in consumer electronic products such as a mobile phone, a notebook computer, a personal computer, etc. The liquid crystal display screen generally includes three parts: an active matrix array substrate, a color filter substrate and a liquid crystal layer. The active matrix array substrate and the color filter substrate are assembled oppositely, and the liquid crystal layer is located between the active matrix array substrate and the color filter substrate. An orientation of liquid crystal molecules in the liquid crystal layer may be adjusted through an active element in the active matrix array substrate, that is, an intensity of a light beam passing through the liquid crystal layer may be adjusted to display an image.

At present, since a resolution of a display panel is getting higher and higher, and various signal lines are becoming denser and denser, a routing around the array substrate may be becoming denser and denser. In order to maintain a good conductivity and an uniformity of each routing, the prior art uses a dense routing that is wide, long and extends in a snake shape. However, such a design is very unfavorable to a realization of a display panel with a narrow frame, and the wide and dense routing arrangement makes it easy for adjacent signal lines to have a short circuit or centralized open circuit therebetween, which may easily cause a low process yield.

The above-mentioned information disclosed in the section is only used to understand a background of the inventive concept of the present disclosure. Therefore, the above-mentioned information may contain an information that does not constitute the prior art.

CN206470722U discloses an array substrate, including: a plurality of first signal lines and a plurality of second signal lines located in a fan-out area; the first signal lines are located in a first metal layer, and the second signal lines are located in a second metal layer; the line widths of the plurality of first signal lines are all equal, and the line widths of the plurality of second signal lines are all equal; the line widths of the first signal lines are greater than the line widths of the second signal lines; the plurality of first signal lines include a plurality of touch signal lines and a plurality of data signal lines; and the plurality of second signal lines include a plurality of data signal lines.

US2014/182894A1 discloses a touch panel, including an electrode layer, a first wire layer, a second wire layer and an insulating layer. The electrode layer is disposed in the sensing region. The first wire layer is disposed in the circuit region and electrically connects to the electrode layer. The second wire layer electrically connects to the first wire layer in the circuit region. The insulating layer has a portion being disposed between the first wire layer and the second wire layer in the circuit, and has a plurality of first through holes wherein the first wire layer electrically connects to the second wire layer through the first through holes. The present disclosure also provides a method of manufacturing a touch panel.

US10775661B2 discloses a touch display device, in which a thin film transistor and touch signal lines are disposed on a substrate. A first insulating layer, a first transparent conductive layer and a second insulating layer are disposed on the thin film transistor and the touch signal lines in sequence, where the first transparent conductive layer includes pixel electrodes. First connecting holes and second connecting holes are situated in the first insulating layer and the second insulating layer, each first connecting hole exposes a portion of the pixel electrode and a portion of the drain, and each second connecting hole exposes a portion of the touch signal line. A second transparent conductive layer is disposed on the second insulating layer, and includes touch electrodes and connecting electrodes electrically insulated from each other and respectively extending into the first connecting holes and the second connecting holes.

### SUMMARY

The invention is set out in the appended set of claims.

According to a first aspect of the present disclosure, there is provided an array substrate, including:
a base substrate including a display region and a peripheral region at least located on at least one side of the display region;
a plurality of pixel cells disposed in the display region, where the pixel cell includes a pixel driving circuit;
a plurality of touch electrodes disposed in the display region;
a plurality of data signal lines at least partially located in the display region, where the plurality of data signal lines are respectively electrically connected to the pixel driving circuit of the plurality of pixel cells and used to respectively transmit a data signal to the plurality of pixel cells;
a plurality of touch signal lines at least partially located in the display region, where the plurality of touch signal lines are respectively electrically connected to the plurality of touch electrodes and used to respectively transmit a touch signal to the plurality of touch electrodes; and
a driving chip located in the peripheral region, where the driving chip is used to provide at least the data signal and the touch signal,
where the peripheral region includes a fan-out region, the fan-out region is located between the display region and the driving chip, the fan-out region includes a first sub-region and a second sub-region, and the first sub-region is closer to the display region than the second sub-region;
the array substrate further includes a plurality of data signal leads located in the fan-out region and a plurality of touch signal leads located in the fan-out region, where ends of the plurality of data signal leads are electrically connected to the driving chip, the other ends of the plurality of data signal leads are electrically connected to the plurality of data signal lines respectively, ends of the plurality of touch signal leads are electrically connected to the driving chip, and the other ends of the plurality of touch signal leads are electrically connected to the plurality of touch signal lines respectively;
at least one of the plurality of data signal leads includes a first data signal sub-lead located in the first sub-region and a second data signal sub-lead located in the second sub-region, and at least one of the plurality of touch signal leads includes a first touch signal sub-lead located in the first sub-region and a second touch signal sub-lead located in the second sub-region;
the plurality of data signal lines and the plurality of touch signal lines are located in a same conductive layer; and
wherein a part of a plurality of second data signal sub-leads are located in a conductive layer different form a conductive layer where the other part of the plurality of second data signal sub-leads are located.

According to embodiments of the present disclosure, the fan-out region further includes a third sub-region, and the third sub-region is closer to the driving chip than the second sub-region;
at least one of the plurality of data signal leads further includes a third data signal sub-lead located in the third sub-region, and at least one of the plurality of touch signal leads further includes a third touch signal sub-lead located in the third sub-region;
the driving chip includes a plurality of contact pins, ends of a plurality of third data signal sub-leads are respectively electrically connected to a part of the plurality of contact pins of the driving chip, and ends of a plurality of third touch signal sub-leads are respectively electrically connected to the other part of the plurality of contact pins of the driving chip; and
an arrangement order of the third data signal sub-lead and the third touch signal sub-lead corresponds to an arrangement order of the plurality of contact pins of the driving chip.

According to embodiments of the present disclosure, a part of the plurality of second data signal sub-leads are located in a first conductive layer, and the other part of the plurality of second data signal sub-leads are located in a second conductive layer; and
each of a plurality of second touch signal sub-leads is located in the first conductive layer.

According to embodiments of the present disclosure, at least one sub-lead in a combination of the plurality of second data signal sub-leads and the plurality of second touch signal sub-leads is located in a conductive layer different form a conductive layer where a sub-lead adjacent to the at least one sub-lead is located.

According to embodiments of the present disclosure, at least one second data signal sub-lead and at least one data signal line which are electrically connected to each other are located in different conductive layers, and the second touch signal sub-lead and the touch signal line which are electrically connected to each other are both located in different conductive layers.

According to embodiments of the present disclosure, the first touch signal sub-lead and the touch signal line which are electrically connected to each other are both located in different conductive layers, and the first touch signal sub-lead and the second touch signal sub-lead which are electrically connected to each other are both located in a same conductive layer.

According to embodiments of the present disclosure, the first touch signal sub-lead, the second touch signal sub-lead and the third touch signal sub-lead which are electrically connected to each other are all located in a same conductive layer.

According to embodiments of the present disclosure, the plurality of data signal lines include at least one first-type data signal line; and
for the at least one first-type data signal line, the data signal line, the first data signal sub-lead and the second data signal sub-lead which are electrically connected to each other are all located in a same conductive layer.

According to embodiments of the present disclosure, the plurality of data signal lines include at least one second-type data signal line; and
for the at least one second-type data signal line, the data signal line and the first data signal sub-lead which are electrically connected to each other are located in a same conductive layer, and the first data signal sub-lead and the second data signal sub-lead which are electrically connected to each other are located in different conductive layers.

According to embodiments of the present disclosure, for the at least one first-type data signal line, the data signal line, the first data signal sub-lead, the second data signal sub-lead and the third data signal sub-lead which are electrically connected to each other are all located in a same conductive layer.

According to embodiments of the present disclosure, for the at least one second-type data signal line, the data signal line and the first data signal sub-lead which are electrically connected to each other are located in the same conductive layer, the first data signal sub-lead and the second data signal sub-lead which are electrically connected to each other are located in the different conductive layers, the first data signal sub-lead and the third data signal sub-lead which are electrically connected to each other are located in different conductive layers, and the second data signal sub-lead and the third data signal sub-lead which are electrically connected to each other are located in a same conductive layer.

According to embodiments of the present disclosure, for the first touch signal sub-lead and the touch signal line which are electrically connected to each other, the touch signal line is electrically connected to the first touch signal sub-lead through a first via hole.

According to embodiments of the present disclosure, for the first data signal sub-lead and the second data signal sub-lead which are located in different conductive layers and electrically connected to each other, the first data signal sub-lead is electrically connected to the second data signal sub-lead through a second via hole.

According to embodiments of the present disclosure, the first via hole is located at a side of the first sub-region close to the display region, and the second via hole is located at a side of the first sub-region close to the second sub-region.

According to embodiments of the present disclosure, in the first sub-region, an orthographic projection of each of at least one first touch signal sub-lead on the base substrate does not intersect with an orthographic projection of any first data signal sub-lead on the base substrate; and/or
in the first sub-region, an orthographic projection of each of at least one first touch signal sub-lead on the base substrate intersects with orthographic projections of at least two first data signal sub-leads on the base substrate.

According to embodiments of the present disclosure, in the first sub-region, a plurality of groups of first touch signal sub-leads are periodically arranged;
a group of first touch signal sub-leads include k first touch signal sub-leads, where k is a positive integer greater than or equal to 3; and
in the group of first touch signal sub-leads, an orthographic projection of a 1^{st} first touch signal sub-lead on the base substrate does not intersect with the orthographic projection of any first data signal sub-lead on the base substrate, an orthographic projection of each of 2^{nd} to (k-1)^{th} first touch signal sub-leads on the base substrate respectively intersects with the orthographic projections of two first data signal sub-leads on the base substrate, and an orthographic projection of a k^{th} first touch signal sub-lead on the base substrate respectively intersects with orthographic projections of four first data signal sub-leads on the base substrate.

According to embodiments of the present disclosure, in the first sub-region, at least a part of an orthographic projection of each of a plurality of first touch signal sub-leads on the base substrate is located between orthographic projections of two first data signal sub-leads electrically connected to the first-type data signal line on the base substrate; and/or
in the first sub-region, an orthographic projection of the first data signal sub-lead electrically connected to the second-type data signal line on the base substrate is located between orthographic projections of two first data signal sub-leads electrically connected to the first-type data signal line on the base substrate.

According to embodiments of the present disclosure, in the second sub-region, any two of the plurality of second data signal sub-leads and the plurality of second touch signal sub-leads are parallel to each other.

According to embodiments of the present disclosure, in the second sub-region, for the combination of the plurality of second data signal sub-leads and the plurality of second touch signal sub-leads, an orthogonal projection of a sub-lead located in the first conductive layer on the base substrate and an orthogonal projection of a sub-lead located in the second conductive layer on the base substrate are alternately arranged; and/or
in the second sub-region, for the combination of the plurality of second data signal sub-leads and the plurality of second touch signal sub-leads, an orthographic projection of a sub-lead located in the first conductive layer on the base substrate at least partially overlaps an orthographic projection of at least one sub-lead adjacent to the sub-lead on the base substrate.

According to embodiments of the present disclosure, the plurality of contact pins of the driving chip include a first contact pin used to provide the data signal and a second contact pin used to provide the touch signal;
the plurality of contact pins are periodically arranged in an order of M first contact pins and N second contact pins, where M is greater than or equal to 2, and N is equal to 1 or 2; and
in the third sub-region, the third data signal sub-lead and the third touch signal sub-lead are periodically arranged in an order of m third data signal sub-leads and n third touch signal sub-leads, where m is equal to M, and n is equal to 1.

According to embodiments of the present disclosure, the pixel driving circuit includes at least one thin film transistor disposed on the base substrate, the thin film transistor includes an active layer, a gate electrode, a source electrode and a drain electrode, and the array substrate includes a pixel electrode and a common electrode; and
where the array substrate includes:
a first conductive layer disposed on the base substrate, where the gate electrode is located in the first conductive layer;
an active layer disposed on a side of the first conductive layer away from the base substrate;
a third conductive layer disposed on a side of the active layer away from the base substrate, where the pixel electrode is located in the third conductive layer;
a second conductive layer disposed on a side of the third conductive layer away from the base substrate, where the source electrode and the drain electrode are located in the second conductive layer; and
a fourth conductive layer disposed on a side of the second conductive layer away from the base substrate, where the common electrode is located in the fourth conductive layer, and
where the plurality of data signal lines and the plurality of touch signal lines are located in the second conductive layer, the plurality of touch signal leads are located in the first conductive layer, the second data signal sub-lead electrically connected to a first-type data signal line is located in the second conductive layer, and the second data signal sub-lead electrically connected to a second-type data signal line is located in the first conductive layer.

According to a second aspect of the present disclosure, there is provided a touch display panel, including the array substrate as described above.

According to a third aspect of the present disclosure, there is provided a display device, including the array substrate as described above or the touch display panel as described above.

According to a fourth aspect of the present disclosure, there is provided a vehicle-mounted display screen, including the array substrate as described above or the touch display panel as described above.

### BRIEF DESCRIPTION OF THE DRAWINGS

Features and advantages of the present disclosure will become more apparent through detailed descriptions of exemplary embodiments of the present disclosure with reference to accompanying drawings.
FIG. 1 is a schematic plan view of an array substrate according to embodiments of the present disclosure.
FIG. 2 is a cross-sectional view of an array substrate taken along line AA' in FIG. 1 according to embodiments of the present disclosure, which schematically shows a cross-sectional structure of the array substrate in a display region.
FIG. 3 is a partial enlarged view of an array substrate at a part II in FIG. 1 according to embodiments of the present disclosure, which schematically shows a wiring design of a fan-out region.
FIG. 4 is a partial enlarged view of an array substrate at a first sub-region of a fan-out region according to embodiments of the present disclosure.
FIG. 5 is a partial enlarged view of an array substrate at a first sub-region of a fan-out region according to other embodiments of the present disclosure.
FIG. 6 is a partial enlarged view of an array substrate at a second sub-region of a fan-out region according to embodiments of the present disclosure.
FIG. 7 is a partial enlarged view of an array substrate at a second sub-region of a fan-out region according to other embodiments of the present disclosure.
FIG. 8 is a partial enlarged view of an array substrate at a third sub-region of a fan-out region according to embodiments of the present disclosure.
FIG. 9 is a partial enlarged view of a driving chip of an array substrate according to embodiments of the present disclosure.
FIG. 10A to FIG. 10C are cross-sectional views of an array substrate taken along line CC' in FIG. 6 according to embodiments of the present disclosure, respectively, which schematically show a double-layer wiring design of the array substrate according to some exemplary embodiments of the present disclosure.
FIG. 11 is a schematic diagram of a display device according to embodiments of the present disclosure.

### DETAILED DESCRIPTION OF EMBODIMENTS

In order to make objectives, technical solutions and advantages of the present disclosure clearer, the technical solution in embodiments of the present disclosure will be described clearly and completely in combination with accompanying drawings.

It should be noted that in the accompanying drawings, a size and a relative size of an element may be enlarged for the purpose of clarity and/or description. As such, the size and the relative size of each element are not necessarily limited to those shown in the drawings. In the specification and the accompanying drawings, the same or similar reference numerals indicate the same or similar components.

When an element is described as being "on", "connected to" or "coupled to" another element, the element may be directly on, directly connected to or directly coupled to the another element, or there may be an intermediate element therebetween. However, when an element is described as being "directly on", "directly connected to" or "directly coupled to" another element, there is no intermediate element therebetween. Other terms and/or expressions used to describe a relationship between elements should be interpreted in a similar way, for example, "between ..." versus "directly between ... ", "adjacent" versus "directly adjacent" or "on ..." versus "directly on ...", etc. In addition, a term "connection" may refer to a physical connection, an electrical connection, a communication connection and/or a fluid connection. In addition, an X axis, a Y axis and a Z axis are not limited to three axes of a rectangular coordinate system, and may be interpreted in a broader sense. For example, the X axis, the Y axis and the Z axis may be perpendicular to each other, or may represent different directions which are not perpendicular to each other. For the purpose of the present disclosure, "at least one of X, Y and Z" and "at least one selected from a group consisting of X, Y and Z" may be interpreted as only X, only Y, only Z, or any combination of two or more of X, Y and Z such as XYZ, XYY, YZ and ZZ. A term "and/or" as used herein includes any combinations and all combinations of one or more of listed related items.

It should be noted that although terms "first", "second", etc. may be used here to describe various parts, components, elements, regions, layers and/or portions, the parts, components, elements, regions, layers and/or portions should not be limited by the terms. Rather, the terms are used to distinguish one part, component, element, region, layer and/or portion from another. Therefore, for example, a first part, a first component, a first element, a first region, a first layer and/or a first portion discussed below may be referred to as a second part, a second component, a second element, a second region, a second layer and/or a second portion without departing from the teaching of the present disclosure.

For the convenience of description, spatial relational terms such as "up", "down", "left", "right", etc. may be used here to describe a relationship between one element or feature and another element or feature as shown in the drawings. It should be understood that the spatial relational terms are intended to cover different orientations of a device in use or operation other than those described in the drawings. For example, if the device in the drawings is upside down, an element described as "below" or "under" another element or feature may be oriented as "up" or "above" the another element or feature.

Those skilled in the art should understand that, unless otherwise specified, an expression "height" or "thickness" used herein refers to a size along a surface of each film layer disposed perpendicular to a display substrate, that is, a size in a light emitting direction of the display substrate, or a size in a normal direction of a display device.

Unless otherwise specified, an expression "patterning process" used herein generally includes steps such as photoresist coating, exposure, development, etching, photoresist stripping, etc. An expression "a patterning process" refers to a process of forming patterned layers, parts, components, etc. using a mask.

It should be noted that "same layer", "disposed on a same layer" or a similar expression refers to a layer structure formed by forming a film layer for formation of specific patterns through a same film forming process, and then patterning the film layer through a patterning process by using a mask. According to different specific patterns, a patterning process may include a plurality of exposure, development or etching processes. The specific patterns in the formed layer structure may be continuous or discontinuous, and they may also be located at different heights or have different thicknesses.

Unless otherwise specified, an expression "electrically connected" may mean that two parts or elements are directly electrically connected, for example, a part or element A is in direct contact with a part or element B, and an electrical signal may be transmitted therebetween; may also mean that two parts or elements are electrically connected through a conductive medium such as a conductive line, for example, a part or element A is electrically connected to a part or element B through a conductive line to transmit an electrical signal between the two parts or elements; and may also mean that two parts or elements are electrically connected through at least one electronic device, for example, a part or element A is electrically connected to a part or element B through at least one thin film transistor to transmit an electrical signal between the two parts or elements.

Embodiments of the present disclosure at least provide an array substrate, a touch display panel, a display device and a vehicle-mounted display screen. The array substrate includes: a base substrate including a display region and a peripheral region at least located on at least one side of the display region; a plurality of pixel cells disposed in the display region, where the pixel cell includes a pixel driving circuit; a plurality of touch electrodes disposed in the display region; a plurality of data signal lines located in the display region, where the plurality of data signal lines are respectively electrically connected to the pixel driving circuit of the plurality of pixel cells and used to respectively transmit a data signal to the plurality of pixel cells; a plurality of touch signal lines located in the display region, where the plurality of touch signal lines are respectively electrically connected to the plurality of touch electrodes and used to respectively transmit a touch signal to the plurality of touch electrodes; and a driving chip located in the peripheral region, where the driving chip is used to provide at least the data signal and the touch signal, where the peripheral region includes a fan-out region, the fan-out region is located between the display region and the driving chip, the fan-out region includes a first sub-region and a second sub-region, and the first sub-region is closer to the display region than the second sub-region; the touch display substrate array substrate further includes a plurality of data signal leads located in the fan-out region and a plurality of touch signal leads located in the fan-out region, where ends of the plurality of data signal leads are electrically connected to the driving chip, the other ends of the plurality of data signal leads are electrically connected to the plurality of data signal lines respectively, ends of the plurality of touch signal leads are electrically connected to the driving chip, and the other ends of the plurality of touch signal leads are electrically connected to the plurality of touch signal lines respectively; at least one of the plurality of data signal leads includes a first data signal sub-lead located in the first sub-region and a second data signal sub-lead located in the second sub-region, and at least one of the plurality of touch signal leads includes a first touch signal sub-lead located in the first sub-region and a second touch signal sub-lead located in the second sub-region; the plurality of data signal lines and the plurality of touch signal lines are located in a same conductive layer; and a part of a plurality of second data signal sub-leads are located in a conductive layer different form a conductive layer where the other part of the plurality of second data signal sub-leads are located. In embodiments of the present disclosure, the data signal leads located in the second sub-region are disposed in two layers. In this way, a width of a frame occupied by the data signal leads located in the second sub-region may be effectively reduced, thereby facilitating a realization of the display device with a narrow frame.

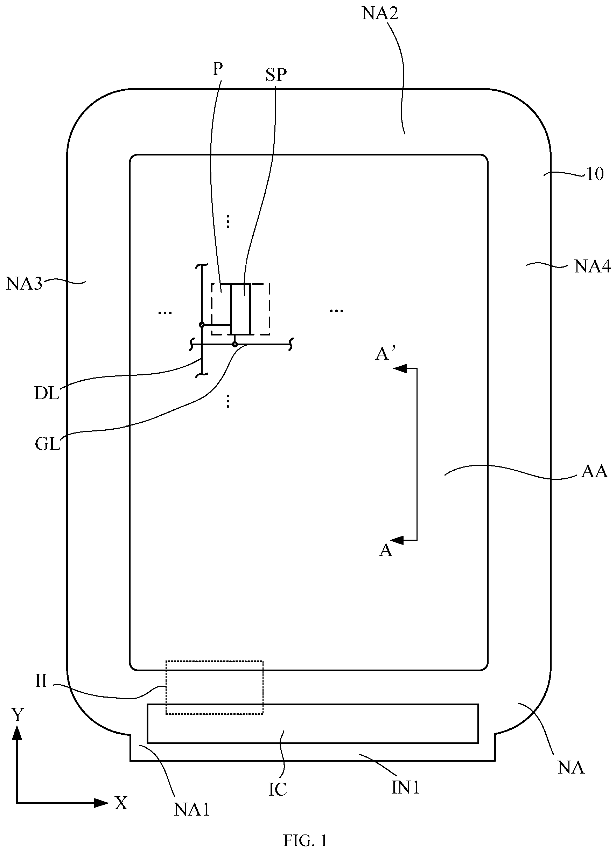

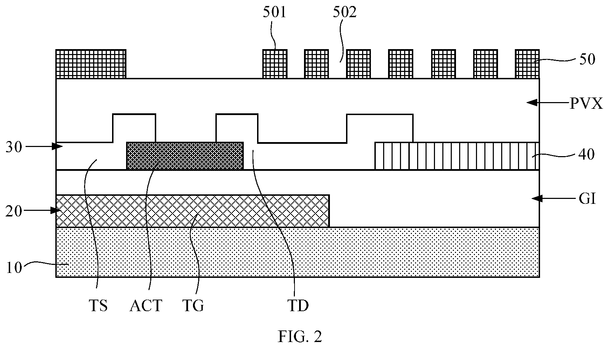

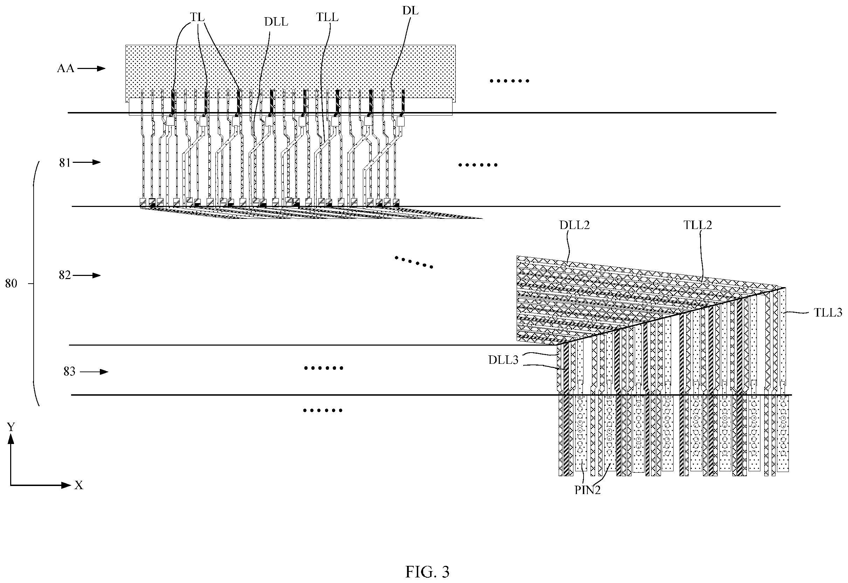

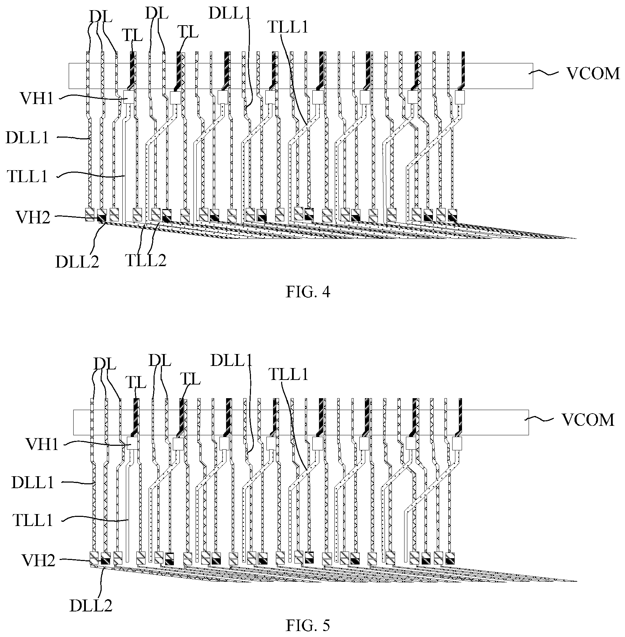

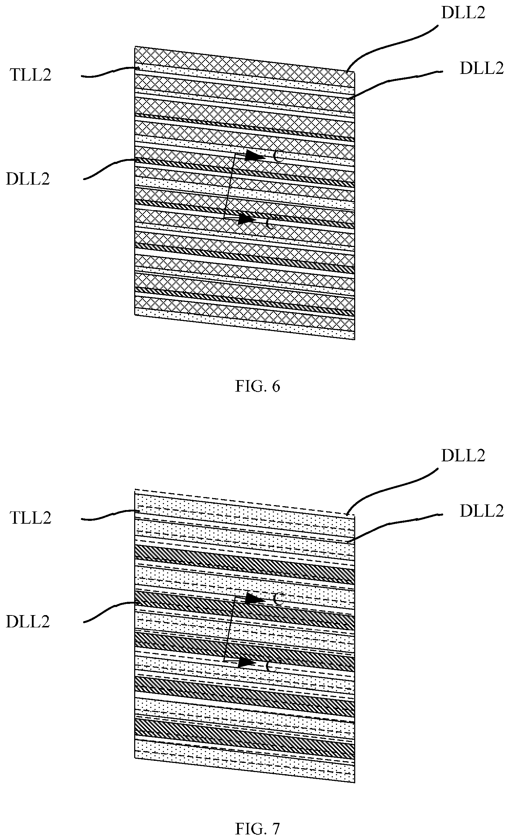

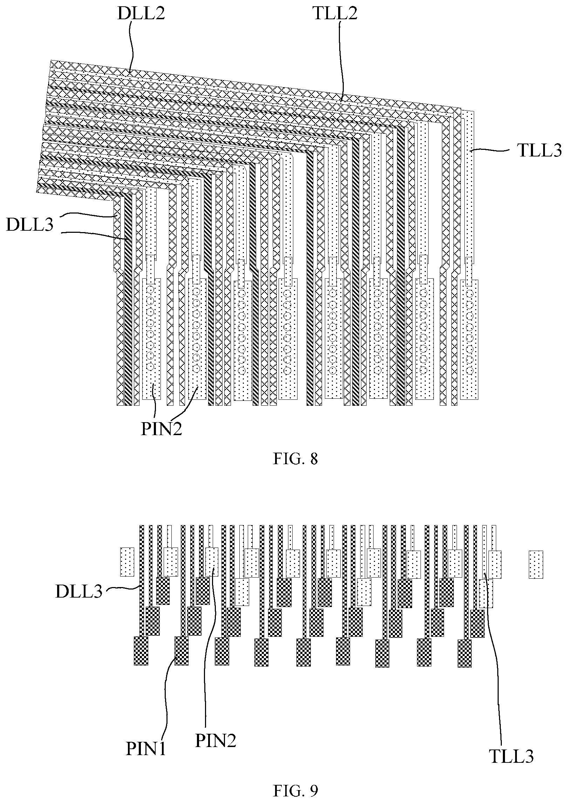

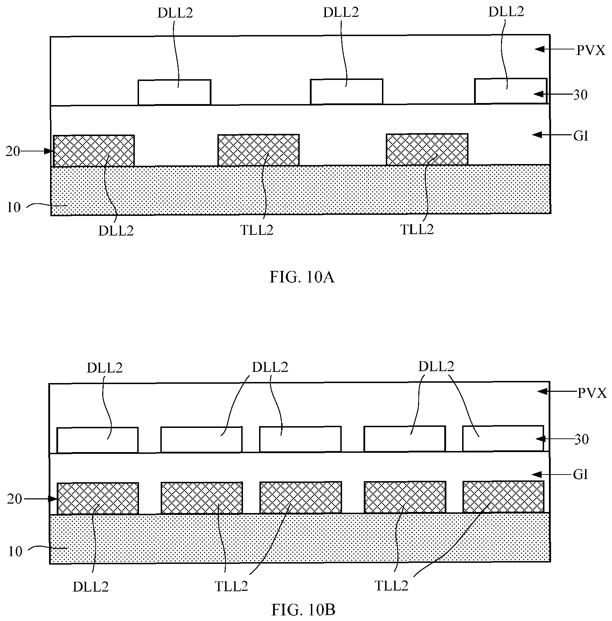

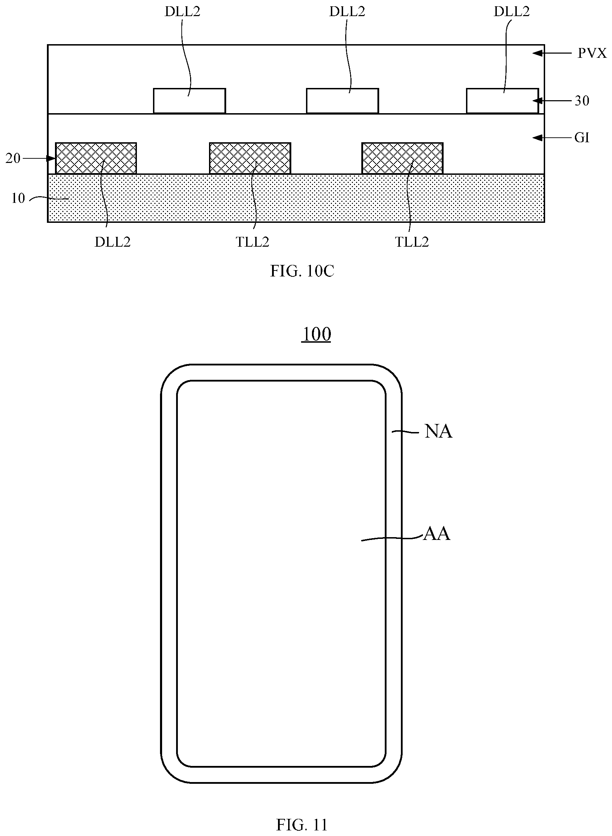

FIG. 1 is a schematic plan view of an array substrate according to embodiments of the present disclosure. FIG. 2 is a cross-sectional view of an array substrate taken along line AA' in FIG. 1 according to embodiments of the present disclosure, which schematically shows a cross-sectional structure of the array substrate in a display region. FIG. 3 is a partial enlarged view of an array substrate at a part II in FIG. 1 according to embodiments of the present disclosure, which schematically shows a wiring design of a fan-out region. FIG. 4 is a partial enlarged view of an array substrate at a first sub-region of a fan-out region according to embodiments of the present disclosure. FIG. 5 is a partial enlarged view of an array substrate at a first sub-region of a fan-out region according to other embodiments of the present disclosure. FIG. 6 is a partial enlarged view of an array substrate at a second sub-region of a fan-out region according to embodiments of the present disclosure. FIG. 7 is a partial enlarged view of an array substrate at a second sub-region of a fan-out region according to other embodiments of the present disclosure. FIG. 8 is a partial enlarged view of an array substrate at a third sub-region of a fan-out region according to embodiments of the present disclosure. FIG. 9 is a partial enlarged view of a driving chip of an array substrate according to embodiments of the present disclosure. FIG. 10A to FIG. 10C are cross-sectional views of an array substrate taken along line CC' in FIG. 6 according to embodiments of the present disclosure, respectively, which schematically show a double-layer wiring design of the array substrate according to some exemplary embodiments of the present disclosure. FIG. 11 is a schematic diagram of a display device according to embodiments of the present disclosure.

Referring to FIG. 1, the array substrate according to embodiments of the present disclosure may include: a base substrate 10. For example, the base substrate 10 may be formed of materials, such as glass, plastic, polyimide, etc. The base substrate 10 includes a display region AA and a peripheral region (or non-display region) NA located on at least one side of the display region AA.

The array substrate may include a plurality of pixel cells P (schematically shown by a dashed box in FIG. 1) disposed in the display region AA, and the plurality of pixel cells P may be arranged in an array on the base substrate 10 in a direction X and a direction Y. Each pixel cell P may further include a plurality of sub-pixels, such as a red sub-pixel, a green sub-pixel and a blue sub-pixel. In FIG. 1, a sub-pixel SP is schematically shown.

For example, the array substrate includes a signal input side IN1 (a lower side shown in FIG. 1). A driving chip IC may be provided on the signal input side IN1. The driving chip IC may be electrically connected to the pixel cell P located in the display region through a plurality of signal routings, and a pixel driving circuit may be electrically connected to the driving chip IC. In this way, signals such as a data signal, a scanning signal, a touch signal, etc. may be transmitted from the signal input side IN1 to the plurality of pixel cells P.

For example, as shown in FIG. 1, the peripheral region NA may be located on four sides of the display region AA, that is, the peripheral region NA surrounds the display region AA.

It should be noted that, in the accompanying drawings, the pixel cells and the sub-pixels are schematically shown in a rectangular shape, but this does not constitute a limitation on shapes of the pixel cells and the sub-pixels included in the array substrate provided by embodiments of the present disclosure.

For example, in some embodiments of the present disclosure, the array substrate may be an array substrate applied to a TFT-LCD. For example, the array substrate may be an array substrate of a liquid crystal display panel. Referring to FIG. 2, the array substrate may include: a pixel electrode 40 disposed on the base substrate 10; an insulating layer PVX disposed on the pixel electrode 40; and a common electrode 50 disposed on the insulating layer PVX. The common electrode 50 is used to cooperate with the pixel electrode 40 to form an electric field that drives a deflection of liquid crystal molecules, thereby realizing a display of a specific gray scale.

In the illustrated embodiments, the pixel electrode 40, the insulating layer PVX and the common electrode 50 are sequentially disposed on the base substrate 10 in a direction away from the base substrate 10. That is, the pixel electrode 40 is located below, and the common electrode 50 is located above.

For example, the pixel electrode 40 may be a planar electrode. That is, the pixel electrode 40 of a sub-pixel P is a planar electrode.

For another example, the common electrode 50 may be a comb-shaped electrode with a plurality of slits 502. That is, a common electrode 50 may include a plurality of electrode portions 501 and the plurality of slits 502, and the plurality of slits 502 separate the plurality of electrode portions 501, respectively. In the array substrate, the comb-shaped common electrode 50 and the planar pixel electrode 40 are stacked on the base substrate of the array substrate, and a multidimensional electric field is formed by an electric field generated at an edge of the comb-shaped common electrode and an electric field generated between the comb-shaped common electrode and the planar pixel electrode in a same plane, so that all oriented liquid crystal molecules between the comb-shaped common electrode and directly above the common electrode in a liquid crystal box may rotate, thereby realizing a display of various gray scales.

It should be noted that the array substrate according to embodiments of the present disclosure is particularly suitable for an ADS (Advanced Super Dimension Switch) mode, and embodiments described herein are described by taking an ADS-mode display panel as an example. However, embodiments of the present disclosure are not limited to this. Embodiments of the present disclosure may also be applied to various display devices in other modes, such as a TN (Twisted Nematic) mode, a VA (Vertical Alignment) mode, etc.

In embodiments of the present disclosure, each of the pixel cells P may include the pixel driving circuit. For example, the pixel driving circuit of each sub-pixel of the array substrate may include at least one thin film transistor located on the base substrate 10. Referring to FIG. 2, the thin film transistor may include a gate electrode TG, a source electrode TS and a drain electrode TD, and may further include a gate insulating layer, an active layer and a passivation layer. A specific structure of the thin film transistor will not be repeated here, please refer to a structure of the thin film transistor in the related art.

Referring to FIG. 2, the array substrate may include: a first conductive layer 20 disposed on the base substrate 10, where the gate electrode TG is located on the first conductive layer 20; an active layer ACT disposed on a side of the first conductive layer 20 away from the base substrate 10; a third conductive layer disposed on a side of the active layer ACT away from the base substrate 10, where the pixel electrode 40 is located on the third conductive layer; a second conductive layer 30 disposed on a side of the third conductive layer away from the base substrate, where the source electrode TS and the drain electrode TD are located in the second conductive layer 30; and a fourth conductive layer disposed on a side of the second conductive layer 30 away from the base substrate 10, where the common electrode 50 is located in the fourth conductive layer.

For example, a first insulating layer GI may be provided between the first conductive layer 20 and the second conductive layer 30. For example, the first insulating layer GI may be a gate insulating layer. A second insulating layer PVX may be provided between the second conductive layer 30 and the fourth conductive layer. For example, the second insulating layer PVX may be a passivation layer.

For example, the array substrate may further include various signal lines disposed on the base substrate 10. The various signal lines include a data signal line, a gate electrode scanning signal line, a touch signal line, a first power supply routing, a second power supply routing, etc., so as to provide various signals such as a data signal, a scanning signal, a touch signal, a first power supply voltage, a second power supply voltage, etc. for the pixel driving circuit in each sub-pixel. In embodiments shown in FIG. 1, a gate electrode scanning signal line GL and a data signal line DL are schematically shown. The gate electrode scanning signal line GL and the data signal line DL may be electrically connected to each pixel cell P.

Referring to FIG. 1, the array substrate according to embodiments of the present disclosure has the display region AA and the peripheral region NA surrounding the display region AA. The peripheral region NA includes a first frame region NA1, a second frame region NA2, a third frame region NA3 and a fourth frame region NA4. For example, the first frame region NA1, the second frame region NA2, the third frame region NA3 and the fourth frame region NA4 may be regarded as a lower frame, an upper frame, a left frame and a right frame of the array substrate, respectively.

Viewed from the front of the array substrate, the array substrate according to embodiments of the present disclosure has a display region and a peripheral region. The display region of the array substrate is provided with a light-emitting pixel and may display an image, and the display region is surrounded by the peripheral region. Typically, when viewed from the front, the display region is surrounded by a frame region. However, for a part of the array substrate, from an aesthetic perspective, the narrower the frame region, the better. Therefore, in applications of a full-screen mobile phone, etc., the left, the right and the top of the display region may not be provided with the frame region. Nevertheless, the array substrate still needs to have at least one frame region for centrally accommodating necessary circuits which are hard to be bent, and the frame region is usually located below the display region. For example, even in a current application of the full-screen mobile phone, a lower frame region in which the image is not display may still exist below the mobile phone. It should be understood that "up", "down", "left", "right", "front" and "back" used herein are only for describing a relative position, not an absolute position between components. In the present disclosure, a lower frame is only for convenience of describing the relative position, but it does not mean that the lower frame is necessarily located below a display screen. In addition, although a conventional array substrate is rectangular and the lower frame region is a rectangular region of one of four sides thereof, other array substrates with outer contour shapes may also have an arbitrary-shaped frame region that centrally accommodates circuits. Any frame with centralized circuit wiring in the array substrate may be regarded as the lower frame, and when the lower frame is described in the present disclosure, it is specified that the lower frame is located below and the display region is accordingly located above.

In embodiments of the present disclosure, the driving chip IC may be disposed in the first frame region NA1. For example, in some embodiments of the present disclosure, a TDDI technology, that is, an integrated technology of touch and display driving, may be used. That is, a touch chip and a display chip may be integrated into a single chip (e.g., the driving chip IC).

For example, referring to FIG. 9, the driving chip IC includes a plurality of contact pins, and the plurality of contact pins of the driving chip include a first contact pin PIN1 used to provide the data signal and a second contact pin PIN2 used to provide the touch signal. For example, in embodiments shown in FIG. 9, leads labeled with Arabic numerals 1, 2, 3, etc. are leads electrically connected to data signal lines, which are electrically connected to the first contact pin PIN1 used to provide the data signal, respectively; leads labeled with English letters A, B, C, etc. are leads electrically connected to the touch signal lines, which are electrically connected to the second contact pin PIN2 used to provide the touch signal, respectively.

For example, in embodiments of the present disclosure, the array substrate may include a first touch layer, a second touch layer, and a touch insulating layer disposed between the first touch layer and the second touch layer which are disposed on the base substrate 10. For example, in the display region AA, the array substrate may include a first touch electrode and a second touch electrode. For example, the first touch electrode may be a touch driving electrode, and the second touch electrode may be a touch sensing electrode. A plurality of first touch electrodes may be arranged in a first direction X, and a plurality of second touch electrodes may be arranged in a second direction intersecting the first direction. In some embodiments, the first direction is perpendicular to the second direction. For example, as illustrated in FIG. 1, the first direction may be a width direction of the array substrate, and the second direction may be a length direction of the array substrate.

The plurality of first touch electrodes located in a same row may be electrically connected through a second connecting portion, and the plurality of second touch electrodes located in a same column may be electrically connected through a first connecting portion.

As an example, shapes of the first touch electrode and the second touch electrode are rhombic, and shapes of the first connecting portion and the second connecting portion are rectangular. However, embodiments of the present disclosure are not limited to this. Those skilled in the art should understand that, in other embodiments, the shapes of the first touch electrode and the second touch electrode and the shapes of the first connecting portion and the second connecting portion may be other shapes.

An orthographic projection of the first connecting portion used to connect the first touch electrode on the base substrate at least partially overlaps an orthographic projection of the second connecting portion used to connect the second touch electrode on the base substrate. That is, the first connecting portion and the second connecting portion have an overlapping region.

In embodiments of the present disclosure, the first touch electrode and the second touch electrode may be located in a same layer, for example, they may be located in the first touch layer. The first connecting portion may also be located in the first touch layer. The second connecting portion may be located in the second touch layer, that is, the second connecting portion forms a conductive bridge portion.

The touch insulating layer is located between the first touch layer and the second touch layer and covers the first touch electrode and the second touch electrode. At least a pair of first via holes are provided in the touch insulating layer, and the first via hole penetrates through the touch insulating layer, so that a part of a region of the first touch electrode may be exposed, which may be called a bridge region. One of each pair of first via holes is located on one of two adjacent first touch electrodes, and the other of each pair of first via holes is located on the other of the two adjacent first touch electrodes.

In some embodiments, a part of the second connecting portion is disposed on a side of the touch insulating layer away from the base substrate, and the rest of the second connecting portion is located in the first via hole. The orthographic projection of the second connecting portion on the base substrate at least partially overlaps orthographic projections of at least one pair of first via holes in the touch insulating layer on the base substrate, so that the second connecting portion may be electrically connected to the first touch electrode through the first via hole overlapped with the second connecting portion, thereby realizing an electrical connection between adjacent first touch electrodes.

In embodiments of the present disclosure, referring to FIG. 1 and 3, the array substrate includes: a plurality of data signal lines DL at least partially located in the display region AA, where the plurality of data signal lines DL are respectively electrically connected to the pixel driving circuit of the plurality of pixel cells P and used to respectively transmit a data signal to the plurality of pixel cells P; and a plurality of touch signal lines TL at least partially located in the display region AA, where the plurality of touch signal lines TL are respectively electrically connected to the plurality of touch electrodes (e.g., the first touch electrode) and used to respectively transmit a touch signal to the plurality of touch electrodes.

The peripheral region includes a fan-out region 80. For example, the fan-out region 80 may be a part of the first frame region NA1. The fan-out region 80 is located between the display region AA and the driving chip IC. The fan-out region 80 includes a first sub-region 81 and a second sub-region 82, and the first sub-region 81 is closer to the display region AA than the second sub-region 82.

For example, the fan-out region 80 further includes a third sub-region 83, and the third sub-region 83 is closer to the driving chip IC than the second sub-region 82. That is to say, the fan-out region 80 may include the first sub-region 81, the second sub-region 82 and the third sub-region 83, and the first sub-region 81, the second sub-region 82 and the third sub-region 83 are sequentially arranged in a direction away from the display region AA.

Referring to FIG. 1, FIG. 2 and FIG. 3, the array substrate further includes a plurality of data signal leads DLL located in the fan-out region 80 and a plurality of touch signal leads TLL located in the fan-out region 80. An end (e.g., an end away from the display region AA) of each of the plurality of data signal leads DLL is electrically connected to the driving chip IC, and the other end (e.g., an end close to the display region AA) of each of the plurality of data signal leads DLL is electrically connected to each of the plurality of data signal lines DL. An end (e.g., an end away from the display region AA) of each of the plurality of touch signal leads TLL is electrically connected to the driving chip IC, and the other end (e.g., an end close to the display region AA) of each of the plurality of touch signal leads TLL is electrically connected to each of the plurality of touch signal lines TL.

Referring to FIG. 3, FIG. 4, FIG. 6 and FIG. 8, at least one of the plurality of data signal leads DLL includes a first data signal sub-lead DLL1 located in the first sub-region 81 and a second data signal sub-lead DLL2 located in the second sub-region 82, and at least one of the plurality of touch signal leads TLL includes a first touch signal sub-lead TLL1 located in the first sub-region 81 and a second touch signal sub-lead TLL2 located in the second sub-region 82.

At least one of the plurality of data signal leads DLL further includes a third data signal sub-lead DLL3 located in the third sub-region 83, and at least one of the plurality of touch signal leads TLL further includes a third touch signal sub-lead TLL3 located in the third sub-region 83.

In embodiments of the present disclosure, the plurality of data signal lines DL and the plurality of touch signal lines TL are located in a same conductive layer, for example, they are all located in the second conductive layer 30. That is to say, in the display region AA, the plurality of data signal lines DL and the plurality of touch signal lines TL are all located in the second conductive layer 30. For example, the plurality of data signal lines DL and the plurality of touch signal lines TL all extend in the direction Y, and the plurality of data signal lines DL and the plurality of touch signal lines TL which are located in the same conductive layer 30 are spaced apart in the direction X. Through such an arrangement, the plurality of data signal lines DL extending longitudinally may conveniently provide data signals for a plurality of rows of sub-pixels, respectively, and the plurality of touch signal lines TL extending longitudinally may conveniently provide touch signals for a plurality of rows of touch cells, respectively.

In embodiments of the present disclosure, a part of a plurality of second data signal sub-leads DLL2 and the other part of the plurality of second data signal sub-leads DLL2 are located in different conductive layers. For example, a part of the second data signal sub-lead DLL2 is located in the first conductive layer 20, and the other part of the second data signal sub-lead DLL2 is located in the second conductive layer 30. That is to say, in embodiments of the present disclosure, the data signal leads located in the second sub-region 82 are disposed in two layers. In this way, a width of a frame occupied by the data signal leads located in the second sub-region 82 may be effectively reduced, thereby facilitating a realization of the display device with a narrow frame.

In embodiments of the present disclosure, a plurality of second touch signal sub-leads TLL2 are all located in a same conductive layer, for example, they are all located in the first conductive layer 20.

In embodiments of the present disclosure, in the second sub-region 82, all the second touch signal sub-leads TLL2 and a part of the second data signal sub-leads DLL2 are all located in the first conductive layer 20, and the other part of the second data signal sub-leads DLL2 is located in the second conductive layer 30. That is, for a combination of a plurality of second data signal sub-leads located in the second sub-region and a plurality of second touch signal sub-leads located in the second sub-region, a part of the signal leads is located in the first conductive layer, and the other part of the signal leads are located in the second conductive layer. Through such an arrangement, the signal leads located in the second sub-region 82 are disposed in two layers. In this way, the width of the frame occupied by the signal leads located in the second sub-region 82 may be effectively reduced, thereby facilitating the realization of the display device with a narrow frame.

In some exemplary embodiments, taking the display device with a resolution of 1920* 1080 as an example, 1920*3 rows of sub-pixels and 1920 rows of touch cells are provided. For example, 3 driving chips IC may be provided. In the example, each driving chip IC needs to lead out 1920 data signal leads and 640 touch signal leads. It can be seen that in the fan-out region 80, especially in the second sub-region 82, a region occupied by the data signal leads is a region that mainly occupies space. In embodiments of the present disclosure, a part of the data signal leads is adjusted to be wired in the first conductive layer, and the other part of the data signal leads and all the touch signal leads are still wired in respective conductive layers thereof, so that the width of the frame occupied by the signal leads located in the second sub-region 82 may be minimized when minimizing a wiring design of the signal leads, thereby facilitating the realization of the display device with a narrow frame.

For example, in exemplary embodiments, 640 data signal leads out of 1920 data signal leads may be adjusted to be wired in the first conductive layer 20, and the other 1280 data signal leads are still wired in the second conductive layer 30. In this way, in the fan-out region 80, especially in the second sub-region 82, 640 data signal leads and 640 touch signal leads may be arranged in the first conductive layer 20. That is, 1280 signal leads may be provided in the first conductive layer 20; 1280 data signal leads may be provided in the second conductive layer 30. That is, in the fan-out region 80, especially in the second sub-region 82, the number of signal leads (e.g., a part of which is the data signal lead and the other part of which is touch signal lead) disposed in the first conductive layer 20 is substantially equal to the number of signal leads (e.g., all of which are data signal leads) disposed in the second conductive layer 30. In this way, the width of the frame occupied by the signal leads located in the second sub-region 82 may be minimized when minimizing the adjustment of the wiring design of the signal leads, thereby facilitating the realization of the display device with a narrow frame.

In embodiments of the present disclosure, for a combination of the plurality of second data signal sub-leads DLL2 located in the second sub-region 82 and the plurality of second touch signal sub-leads TLL2 located in the second sub-region 82, at least one sub-lead in the combination of the plurality of second data signal sub-leads DLL2 and the plurality of second touch signal sub-leads TLL2 and a sub-lead adjacent to the at least one sub-lead are located in different conductive layers. For example, any sub-lead in the combination of the plurality of second data signal sub-leads DLL2 and the plurality of second touch signal sub-leads TLL2 and a sub-lead adjacent to the sub-lead are located in different conductive layers. It should be noted that "any sub-lead" here means that the sub-lead may be the second data signal sub-lead DLL2 or the second touch signal sub-lead TLL2. For example, in the second sub-region 82, the signal lead located in the first conductive layer 20 and the signal lead located in the second conductive layer 30 are alternately arranged. Referring to FIG. 4, FIG. 5, FIG. 6 and FIG. 7, data leads wired in two layers are alternately arranged in the following manner: from a left side to a right side of FIG. 4, the second data signal sub-lead DLL2 located in the second conductive layer 30, the second data signal sub-lead DLL2 located in the first conductive layer 20, the second data signal sub-lead DLL2 located in the second conductive layer 30, the second touch signal sub-lead TLL2 located in the first conductive layer 20, the second data signal sub-lead DLL2 located in the second conductive layer 30, the second touch signal sub-lead TLL2 located in the first conductive layer 20, the second data signal sub-lead DLL2 located in the second conductive layer 30, the second data signal sub-lead DLL2 located in the first conductive layer 20, and so on.

In embodiments of the present disclosure, at least one second data signal sub-lead (e.g., a part of the second data signal sub-leads DLL2 located in the first conductive layer 20) and at least one data signal line DL which are electrically connected to each other are located in different conductive layers. In embodiments of the present disclosure, the second touch signal sub-lead TLL2 and the touch signal line TL which are electrically connected to each other are located in different conductive layers. For example, the second touch signal sub-lead TLL2 is located in the first conductive layer 20, and the touch signal line TL is located in the second conductive layer 30.

In embodiments of the present disclosure, the first touch signal sub-lead TTL1 and the touch signal line TL which are electrically connected to each other are located in different conductive layers, and the first touch signal sub-lead TTL1 and the second touch signal sub-lead TTL2 which are electrically connected to each other are located in a same conductive layer. For example, the first touch signal sub-lead TTL1 and the second touch signal sub-lead TTL2 are both located in the first conductive layer 20, and the touch signal line TL is located in the second conductive layer 30.

Further, the first touch signal sub-lead TTL1, the second touch signal sub-lead TTL2 and the third touch signal sub-lead TTL3 which are electrically connected to each other are all located in a same conductive layer. For example, the first touch signal sub-lead TTL1, the second touch signal sub-lead TTL2 and the third touch signal sub-lead TTL3 are all located in the first conductive layer 20.

In embodiments of the present disclosure, the plurality of data signal lines DL may include at least one first-type data signal line and at least one second-type data signal line. For example, for the first-type of data signal line, the data signal lead electrically connected thereto may be arranged in the same conductive layer as the data signal line; for the second-type of data signal line, a part of the data signal lead electrically connected thereto may be arranged in a conductive layer different from the data signal line. It should be noted that, in the present disclosure, unless otherwise specified, use of prefixes of first-type and second-type to modify the data signal lines is only for the purpose of explaining a difference in wirings of the data signal leads electrically connected thereto, and is not intended to distinguish the data signal lines themselves.

For example, for the at least one first-type data signal line, the data signal line DL, the first data signal sub-lead DLL 1 and the second data signal sub-lead DLL2 which are electrically connected to each other are located in a same conductive layer. For example, in FIG. 4, the 1^{st}, 3^{rd} 4^{th}, 5^{th} and 7^{th} data signal lines counting from the left are all first-type data signal lines.

For example, for the at least one second-type data signal line, the data signal line DL and the first data signal sub-lead DLL1 which are electrically connected to each other are located in a same conductive layer, and the first data signal sub-lead DLL1 and the second data signal sub-lead DLL2 which are electrically connected to each other are located in different conductive layers. For example, the data signal line DL and the first data signal sub-lead DLL1 which are electrically connected to each other are located in the second conductive layer 30, and the second data signal sub-lead DLL2 is located in the first conductive layer 20. For example, in FIG. 4, the 2^{nd} and 6^{th} data signal lines counting from the left are all second-type data signal lines.

Referring to FIG. 3, FIG. 4 and FIG. 8, for the at least one first-type data signal line, the data signal line DL, the first data signal sub-lead DLL1, the second data signal sub-lead DLL2 and the third data signal sub-lead DLL3 which are electrically connected to each other are all located in a same conductive layer, for example, in the second conductive layer 30.

For the at least one second-type data signal line, the data signal line DL and the first data signal sub-lead DLL1 which are electrically connected to each other are located in the same conductive layer, the first data signal sub-lead DLL1 and the second data signal sub-lead DLL2 which are electrically connected to each other are located in the different conductive layers, the first data signal sub-lead DLL1 and the third data signal sub-lead DLL3 which are electrically connected to each other are located in the same conductive layer, and the second data signal sub-lead DLL2 and the third data signal sub-lead DLL3 which are electrically connected to each other are located in the same conductive layer. For example, the data signal line DL and the first data signal sub-lead DLL1 are located in the second conductive layer 30, and the second data signal sub-lead DLL2 and the third data signal sub-lead DLL3 are located in the first conductive layer 20.

Referring to FIG. 4, for the first touch signal sub-lead TLL1 and the touch signal line TL which are electrically connected to each other, the touch signal line TL is electrically connected to the first touch signal sub-lead TLL1 through a first via hole VH1. For the first data signal sub-lead DLL1 and the second data signal sub-lead DLL2 which are located in different conductive layers and electrically connected to each other, the first data signal sub-lead DLL1 is electrically connected to the second data signal sub-lead DLL1 through a second via hole VH2.

It should be noted that in the present disclosure, unless otherwise specified, a boundary where the first sub-region 81 adjoins the second sub-region 82 passes through the first via hole VH1 of a touch line. Accordingly, the data signal line DL and the touch signal line TL both extend from the display region AA to the peripheral region NA.

In embodiments shown in FIG. 4, the first via hole VH1 is located on a side of the first sub-region 81 close to the display region AA, and the second via hole VH2 is located on a side of the first sub-region 81 close to the second sub-region 82. That is to say, in embodiments of the present disclosure, the touch signal line and the touch signal lead realize a layer-changing switching at the side of the first sub-region 81 close to the display region AA, and a part of the data signal lines and the data signal leads realize the layer-changing switching at a side of the first sub-region 81 away from the display region AA. For example, the array substrate may further include a first power supply routing VCOM extending in the direction X. For example, the first power supply routing VCOM may be a routing used to transmit a voltage signal to the common electrode. The first via hole VH1 may be located on a side of the first power supply routing VCOM away from the display region AA, and the first via hole VH1 is close to the first power supply routing VCOM.

Through the layer-changing switching mode, in the first sub-region 81, at least most of the first data signal sub-leads are located in the second conductive layer 30. In this way, the first touch signal sub-lead TLL1 located in the first conductive layer 20 may be wound and wired. For example, in embodiments shown in FIG. 4, a part of the first touch signal sub-leads TLL1 (the 2^{nd} to 8^{th} first touch signal sub-leads counting from the left,) may span the plurality of first data signal sub-leads. In this way, in the subsequent second sub-region 82, the signal leads located in the first conductive layer 20 and the signal leads located in the second conductive layer 30 may be alternately arranged.

In some embodiments of the present disclosure, in the first sub-region 81, an orthographic projection of each of at least one first touch signal sub-lead TLL1 (e.g., the 1^{st} and 9^{th} first touch signal sub-leads counting from the left in embodiments shown in FIG. 4) on the base substrate 10 does not intersect with an orthographic projection of any first data signal sub-lead DLL1 on the base substrate 10. In the first sub-region 81, the orthographic projection of each of the at least one first touch signal sub-lead (e.g., the 2^{nd} to 8^{th} first touch signal sub-leads counting from the left in embodiments shown in FIG. 4) on the base substrate 10 intersects with orthographic projections of at least two first data signal sub-leads DLL1 on the base substrate 10.

In some exemplary embodiments, in the first sub-region 81, a plurality of groups of first touch signal sub-leads TLL1 are periodically arranged. A group of first touch signal sub-leads includes k first touch signal sub-leads TLL1, where k is a positive integer greater than or equal to 3. In the group of first touch signal sub-leads TLL1, an orthographic projection of a 1^{st} first touch signal sub-lead on the base substrate does not intersect with the orthographic projection of any first data signal sub-lead on the base substrate, and an orthographic projection of each of the 2^{nd} to (k-1)^{th} first touch signal sub-leads on the base substrate intersects with the orthographic projections of two first data signal sub-leads on the base substrate, respectively, and an orthographic projection of a k^{th} first touch signal sub-lead on the base substrate intersects with orthographic projections of four first data signal sub-leads on the base substrate, respectively.

For example, in embodiments shown in FIG. 4, the orthographic projection of each of the 2^{nd} to 7^{th} first touch signal sub-leads counting from the left on the base substrate 10 intersects with orthographic projections of two first data signal sub-leads DLL1 on the base substrate 10, and the orthographic projection of each of the 8^{th} first touch signal sub-leads on the base substrate 10 intersects with orthographic projections of four first data signal sub-leads DLL1 on the base substrate 10. Through such a winding and wiring design, in the subsequent second sub-region 82, an alternate arrangement of the signal leads located in the first conductive layer 20 and the signal leads located in the second conductive layer 30 may be realized.

In some embodiments of the present disclosure, in the first sub-region 81, at least a part of an orthographic projection of each of a plurality of first touch signal sub-leads TLL1 on the base substrate 10 is located between the orthographic projections of the two first data signal sub-leads DLL1 electrically connected to the first-type data signal line on the base substrate 10. In the first sub-region 81, the orthographic projection of the first data signal sub-lead DLL1 electrically connected to the second-type data signal line on the base substrate 10 is located between the orthographic projections of the two first data signal sub-leads DLL1 electrically connected to the first-type data signal line on the base substrate 10.

Referring to FIG. 6, in the second sub-region 82, any two of the plurality of second data signal sub-leads DLL2 and the plurality of second touch signal sub-leads TLL2 are parallel to each other. For example, in the second sub-region 82, any two of the plurality of second data signal sub-leads DLL2 are parallel to each other, any two of the plurality of second touch signal sub-leads TLL2 are parallel to each other, and any one of the plurality of second data signal sub-leads DLL2 and any one of the plurality of second touch signal sub-leads TLL2 are parallel to each other.

In some embodiments of the present disclosure, in the first sub-region 81, main portions of the first data signal sub-lead DLL1 and the first touch signal sub-lead TLL1 substantially extend in the direction Y; in the second sub-region 82, main portions of the second data signal sub-lead DLL2 and the second touch signal sub-lead TLL2 substantially extend in a direction inclined with respect to the direction Y, so as to converge the plurality of data signal leads and the plurality of touch signal leads toward a direction of the driving chip IC.

Referring to FIG. 10A to FIG. 10C, in the second sub-region 82, for the combination of the plurality of second data signal leads DLL2 and the plurality of second touch signal leads TLL2, an orthographic projection of a lead located in the first conductive layer 20 on the base substrate 10 and an orthographic projection of a lead located in the second conductive layer 30 on the base substrate 10 are alternately arranged. In combination with the above-mentioned descriptions, the "lead located in the first conductive layer 20" here may include all the second touch signal sub-leads TLL2 and a part of the second data signal sub-leads DLL2 located in the first conductive layer 20; and the "lead in the second conductive layer 30" here may include a part of the second data signal sub-leads DLL2 in the second conductive layer 30.

For example, in the second sub-region 82, for the combination of the plurality of second data signal leads DLL2 and the plurality of second touch signal leads TLL2, the orthographic projection of the lead located in the first conductive layer 20 on the base substrate 10 at least partially overlaps an orthographic projection of at least one lead adjacent to the lead on the base substrate 10. For example, the orthographic projection of the lead located in the first conductive layer 20 on the base substrate 10 completely overlaps the orthographic projection of a lead adjacent to the lead on the base substrate 10. The width of the frame occupied by the signal leads located in the second sub-region 82 may be minimized by the wiring method, thereby facilitating the realization of the display device with a narrow frame.

Referring to FIG. 8 and FIG. 9, in embodiments of the present disclosure, ends of a plurality of third data signal sub-leads DLL3 are electrically connected to a part of the contact pins PIN1 of the driving chip IC, and ends of a plurality of third touch signal sub-leads TLL3 are electrically connected to the contact pins PIN2 of the driving chip IC. An arrangement order of the third data signal sub-lead DLL3 and the third touch signal sub-lead TLL3 corresponds to an arrangement order of the plurality of contact pins PIN1 and PIN2 of the driving chip IC.

For example, the plurality of contact pins may be arranged periodically in an order of M first contact pins PIN1 and N second contact pins PIN2, where M is greater than or equal to 2, and N is equal to 1 or 2. For example, in embodiments shown in FIG. 9, the plurality of contact pins may be arranged periodically in an order of 2 to 3 first contact pins PIN1 and 1 to 2 second contact pins PIN2. Specifically, starting from a left side in FIG. 9, 3 first contact pins PIN1 and 1 second contact PIN2, 3 first contact pins PIN1 and 1 second contact PIN2, and 2 first contact pins PIN1 and 2 second contact pins PIN2 are sequentially arranged as an arrangement cycle.

In embodiments shown in FIG. 8, in the third sub-region 83, the third data signal sub-lead DLL3 and the third touch signal sub-lead TLL3 are periodically arranged in an order of m third data signal sub-leads DLL3 and n third touch signal sub-leads TLL3, where m is equal to M, and n is equal to 1. For example, the third data signal sub-lead DLL3 and the third touch signal sub-lead TLL3 are periodically arranged in an order of 2 to 3 third data signal sub-leads DLL3 and 1 third touch signal sub-lead TLL3, where m is equal to M, and n is equal to 1. Specifically, starting from a left side in FIG. 8, 3 third data signal sub-leads DLL3 and 1 third touch signal sub-lead TLL3, 3 third data signal sub-leads DLL3 and 1 third touch signal sub-lead TLL3, and 2 third data signal sub-leads DLL3 and 1 third touch signal sub-lead TLL3 are sequentially arranged as an arrangement cycle.

It should be noted that, in embodiments shown in FIG. 8 and FIG. 9, the number N of the second contact pins PIN2 may be greater than the number n of the third touch signal sub-leads TLL3 in a partial arrangement cycle. A part of the second contact pins PIN2 may be dummy contact pins, which are not connected to actual touch signal leads. For example, in embodiments shown in FIG. 9, the second contact pins PIN2 labeled with D, H and L may be the dummy contact pins, which are not connected to the actual touch signal leads.

FIG. 11 is a schematic diagram of a display device according to some exemplary embodiments of the present disclosure. The display device 100 includes the above-mentioned array substrate. For example, the array substrate includes the display region AA and the peripheral region NA. Film structures in the display region AA and the peripheral region NA will not be repeated here, please refer to the above-mentioned descriptions of various embodiments.

The display device may include any apparatus or product with a display function. For example, the display device may be a smart phone, a mobile phone, an e-book reader, a desktop computer (PC), a laptop computer PC, a netbook PC, a personal digital assistant (PDA), a portable multimedia player (PMP), a digital audio player, a mobile medical apparatus, a camera, a wearable apparatus (such as a head-mounted apparatus, an electronic clothing, an electronic bracelet, an electronic necklace, an electronic accessory, an electronic tattoo or a smart watch), a television, etc.

Embodiments of the present disclosure further provide a vehicle-mounted display screen, including the above-mentioned array substrate or the above-mentioned touch display panel.

It should be understood that the display device and the vehicle-mounted display screen according to embodiments of the present disclosure have all the features and advantages of the above-mentioned array substrate, please refer to the above-mentioned descriptions for details.

## Claims

1. An array substrate, comprising:
a base substrate (10) comprising a display region (AA) and a peripheral region (NA) at least located on at least one side of the display region (AA);
a plurality of pixel cells (P) disposed in the display region (AA), wherein the pixel cell comprises a pixel driving circuit;
a plurality of touch electrodes disposed in the display region (AA);
a plurality of data signal lines (DL) at least partially located in the display region (AA), wherein the plurality of data signal lines (DL) are respectively electrically connected to the pixel driving circuit of the plurality of pixel cells (P) and configured to respectively transmit a data signal to the plurality of pixel cells (P);
a plurality of touch signal lines (TL) at least partially located in the display region (AA), wherein the plurality of touch signal lines (TL) are respectively electrically connected to the plurality of touch electrodes and configured to respectively transmit a touch signal to the plurality of touch electrodes; and
a driving chip (IC) located in the peripheral region (NA), wherein the driving chip (IC) is configured to provide at least the data signal and the touch signal,
wherein the peripheral region (NA) comprises a fan-out region, the fan-out region is located between the display region (AA) and the driving chip (IC), the fan-out region comprises a first sub-region and a second sub-region, the first sub-region is closer to the display region (AA) than the second sub-region, and the first sub-region and the second sub-region do not overlap with each other;
wherein the array substrate further comprises a plurality of data signal leads located in the fan-out region and a plurality of touch signal leads (TLL) located in the fan-out region, wherein ends of the plurality of data signal leads are electrically connected to the driving chip (IC), the other ends of the plurality of data signal leads are electrically connected to the plurality of data signal lines (DL) respectively, ends of the plurality of touch signal leads (TLL) are electrically connected to the driving chip (IC), and the other ends of the plurality of touch signal leads (TLL) are electrically connected to the plurality of touch signal lines (TL) respectively;
wherein at least one of the plurality of data signal leads comprises a first data signal sub-lead (DLL1) located in the first sub-region and a second data signal sub-lead located in the second sub-region, the first data signal sub-lead (DLL1) is electrically connected between the second data signal sub-lead and a respective data signal line (DL); and at least one of the plurality of touch signal leads (TLL) comprises a first touch signal sub-lead (TLL1) located in the first sub-region and a second touch signal sub-lead (TLL2) located in the second sub-region, and the first touch signal sub-lead (TLL1) is electrically connected between the second touch signal sub-lead (TLL2) and a respective touch signal line (TL);
wherein the plurality of data signal lines (DL) and the plurality of touch signal lines (TL) are located in a same conductive layer;
wherein a part of a plurality of second data signal sub-leads (DLL2) are located in a conductive layer different form a conductive layer where the other part of the plurality of second data signal sub-leads (DLL2) are located;
wherein a part of the plurality of second data signal sub-leads (DLL2) are located in a first conductive layer (20), and the other part of the plurality of second data signal sub-leads (DLL2) are located in a second conductive layer (30),
**characterized in that** orthographic projections of the second data signal sub-leads (DLL2) in the first conductive layer (20) on the base substrate (10) overlap orthographic projections of the second data signal sub-leads (DLL2) in the second conductive layer (30) on the base substrate (10).

2. The array substrate according to claim 1, wherein the fan-out region further comprises a third sub-region, and the third sub-region is closer to the driving chip (IC) than the second sub-region;
at least one of the plurality of data signal leads further comprises a third data signal sub-lead (DLL3) located in the third sub-region, and at least one of the plurality of touch signal leads (TLL) further comprises a third touch signal sub-lead (TLL3) located in the third sub-region;
the driving chip (IC) comprises a plurality of contact pins, ends of a plurality of third data signal sub-leads (DLL3) are respectively electrically connected to a part of the plurality of contact pins of the driving chip (IC), and ends of a plurality of third touch signal sub-leads (TLL3) are respectively electrically connected to the other part of the plurality of contact pins of the driving chip (IC); and
an arrangement order of the third data signal sub-lead (DLL3) and the third touch signal sub-lead (TLL3) corresponds to an arrangement order of the plurality of contact pins of the driving chip (IC).

3. The array substrate according to claim 1 or 2, wherein each of the plurality of second touch signal sub-leads (TLL2) is located in the first conductive layer (20),
wherein at least one sub-lead in a combination of the plurality of second data signal sub-leads (DLL2) and the plurality of second touch signal sub-leads (TLL2) is located in a conductive layer different form a conductive layer where a sub-lead adjacent to the at least one sub-lead is located.

4. The array substrate according to claim 3, wherein at least one second data signal sub-lead (DLL2) and at least one data signal line (DL) which are electrically connected to each other are located in different conductive layers, and the second touch signal sub-lead (TLL2) and the touch signal line (TL) which are electrically connected to each other are both located in different conductive layers.

5. The array substrate according to claim 3, wherein the first touch signal sub-lead (TLL1) and the touch signal line (TL) which are electrically connected to each other are both located in different conductive layers, and the first touch signal sub-lead (TLL1) and the second touch signal sub-lead (TLL2) which are electrically connected to each other are both located in a same conductive layer.

6. The array substrate according to claim 5, wherein the first touch signal sub-lead (TLL1), the second touch signal sub-lead (TLL2) and the third touch signal sub-lead (TLL3) which are electrically connected to each other are all located in a same conductive layer.

7. The array substrate according to claim 4, wherein the plurality of data signal lines (DL) comprise at least one first-type data signal line; and
for the at least one first-type data signal line, the data signal line (DL), the first data signal sub-lead (DLL1) and the second data signal sub-lead (DLL2) which are electrically connected to each other are all located in a same conductive layer, wherein the plurality of data signal lines (DL) comprise at least one second-type data signal line; and
for the at least one second-type data signal line, the data signal line (DL) and the first data signal sub-lead (DLL1) which are electrically connected to each other are located in a same conductive layer, and the first data signal sub-lead (DLL1) and the second data signal sub-lead (DLL2) which are electrically connected to each other are located in different conductive layers.

8. The array substrate according to claim 7, wherein for the at least one first-type data signal line, the data signal line (DL), the first data signal sub-lead (DLL1), the second data signal sub-lead (DLL2) and the third data signal sub-lead (DLL3) which are electrically connected to each other are all located in a same conductive layer,
wherein for the at least one second-type data signal line, the data signal line (DL) and the first data signal sub-lead (DLL1) which are electrically connected to each other are located in the same conductive layer, the first data signal sub-lead (DLL1) and the second data signal sub-lead (DLL2) which are electrically connected to each other are located in the different conductive layers, the first data signal sub-lead (DLL1) and the third data signal sub-lead (DLL3) which are electrically connected to each other are located in different conductive layers, and the second data signal sub-lead (DLL2) and the third data signal sub-lead (DLL3) which are electrically connected to each other are located in a same conductive layer.

9. The array substrate according to claim 7, wherein for the first touch signal sub-lead (TLL1) and the touch signal line (TL) which are electrically connected to each other, the touch signal line (TL) is electrically connected to the first touch signal sub-lead (TLL1) through a first via hole (VH1),
wherein for the first data signal sub-lead (DLL1) and the second data signal sub-lead (DLL2) which are located in different conductive layers and electrically connected to each other, the first data signal sub-lead (DLL1) is electrically connected to the second data signal sub-lead (DLL2) through a second via hole (VH2),
wherein the first via hole (VH1) is located at a side of the first sub-region close to the display region (AA), and the second via hole (VH2) is located at a side of the first sub-region close to the second sub-region,
wherein in the first sub-region, an orthographic projection of each of at least one first touch signal sub-lead (TLL1) on the base substrate (10) does not intersect with an orthographic projection of any first data signal sub-lead (DLL1) on the base substrate (10); and/or
in the first sub-region, an orthographic projection of each of at least one first touch signal sub-lead (TLL1) on the base substrate (10) intersects with orthographic projections of at least two first data signal sub-leads (DLL1) on the base substrate (10),
wherein in the first sub-region, a plurality of groups of first touch signal sub-leads (TTL1) are periodically arranged;
a group of first touch signal sub-leads (TLL1) comprise k first touch signal sub-leads (TLL1), where k is a positive integer greater than or equal to 3; and
in the group of first touch signal sub-leads (TLL1), an orthographic projection of a 1^{st} first touch signal sub-lead on the base substrate (10) does not intersect with the orthographic projection of any first data signal sub-lead (DLL1) on the base substrate (10), an orthographic projection of each of 2^{nd} to (k-1)^{th} first touch signal sub-leads on the base substrate (10) respectively intersects with the orthographic projections of two first data signal sub-leads (DLL1) on the base substrate (10), and an orthographic projection of a k^{th} first touch signal sub-lead on the base substrate respectively intersects with orthographic projections of four first data signal sub-leads (DLL1) on the base substrate (10).

10. The array substrate according to claim 7, wherein in the first sub-region, at least a part of an orthographic projection of each of a plurality of first touch signal sub-leads (TLL1) on the base substrate (10) is located between orthographic projections of two first data signal sub-leads (DLL1) electrically connected to the first-type data signal line on the base substrate (10); and/or
in the first sub-region, an orthographic projection of the first data signal sub-lead (DLL1) electrically connected to the second-type data signal line on the base substrate (10) is located between orthographic projections of two first data signal sub-leads (DLL1) electrically connected to the first-type data signal line on the base substrate (10).

11. The array substrate according to claim 6, wherein in the second sub-region, any two of the plurality of second data signal sub-leads (DLL2) and the plurality of second touch signal sub-leads (TLL2) are parallel to each other,
wherein in the second sub-region, for a combination of the plurality of second data signal sub-leads (DLL2) and the plurality of second touch signal sub-leads (TLL2), an orthographic projection of a sub-lead located in the first conductive layer (20) on the base substrate (10) at least partially overlaps an orthographic projection of at least one sub-lead adjacent to the sub-lead on the base substrate (10),
wherein the plurality of contact pins of the driving chip (IC) comprise a first contact pin configured to provide the data signal and a second contact pin configured to provide the touch signal;
the plurality of contact pins are periodically arranged in an order of M first contact pins and N second contact pins, where M is greater than or equal to 2, and N is equal to 1 or 2; and
in the third sub-region, the third data signal sub-lead (DLL3) and the third touch signal sub-lead (TLL3) are periodically arranged in an order of m third data signal sub-leads and n third touch signal sub-leads, where m is equal to M, and n is equal to 1.

12. The array substrate according to any one of claim 1 to 5, wherein the pixel driving circuit comprises at least one thin film transistor disposed on the base substrate (10), the thin film transistor comprises an active layer, a gate electrode (TG), a source electrode (TS) and a drain electrode (TD), and the array substrate comprises a pixel electrode (40) and a common electrode (50); and
wherein the array substrate comprises:
a first conductive layer (20) disposed on the base substrate (10), wherein the gate electrode (TG) is located in the first conductive layer (20);
an active layer (ACT) disposed on a side of the first conductive layer (20) away from the base substrate (10);
a third conductive layer disposed on a side of the active layer (ACT) away from the base substrate (10), wherein the pixel electrode (40) is located in the third conductive layer;
a second conductive layer (30) disposed on a side of the third conductive layer away from the base substrate (10), wherein the source electrode (TS) and the drain electrode (TD) are located in the second conductive layer (30); and
a fourth conductive layer disposed on a side of the second conductive layer (30) away from the base substrate (10), wherein the common electrode (50) is located in the fourth conductive layer, and
wherein the plurality of data signal lines (DL) and the plurality of touch signal lines (TL) are located in the second conductive layer (30), the plurality of touch signal leads (TLL) are located in the first conductive layer (20), the second data signal sub-lead (DLL2) electrically connected to a first-type data signal line is located in the second conductive layer (30), and the second data signal sub-lead (DLL2) electrically connected to a second-type data signal line is located in the first conductive layer (20).

13. A touch display panel comprising the array substrate according to any one of claims 1 to 12.

14. A display device comprising the array substrate according to any one of claims 1 to 12 or the touch display panel according to claim 13.

15. A vehicle-mounted display screen comprising the array substrate according to any one of claims 1 to 12 or the touch display panel according to claim 13.

## Patentansprüche

1. Arraysubstrat, umfassend:
ein Basissubstrat (10), umfassend einen Anzeigebereich (AA) und einen Randbereich (NA), der sich zumindest auf zumindest einer Seite des Anzeigebereichs (AA) befindet;
eine Vielzahl von Pixelzellen (P), die im Anzeigebereich (AA) angeordnet sind, wobei die Pixelzelle eine Pixeltreiberschaltung umfasst;
eine Vielzahl von Berührungselektroden, die im Anzeigebereich (AA) angeordnet sind;
eine Vielzahl von Datensignalanschlüssen (DL), die sich zumindest teilweise im Anzeigebereich (AA) befinden, wobei die Vielzahl von Datensignalanschlüssen (DL) jeweils elektrisch mit der Pixeltreiberschaltung der Vielzahl von Pixelzellen (P) verbunden und dazu konfiguriert ist, jeweils ein Datensignal an die Vielzahl von Pixelzellen (P) zu übertragen;
eine Vielzahl von Berührungssignalanschlüssen (TL), die zumindest teilweise im Anzeigebereich (AA) angeordnet sind, wobei die Vielzahl von Berührungssignalanschlüssen (TL) jeweils elektrisch mit der Vielzahl von Berührungselektroden verbunden und dazu konfiguriert sind, jeweils ein Berührungssignal an die Vielzahl von Berührungselektroden zu übertragen; und
einen Treiberchip (IC), der im peripheren Bereich (NA) angeordnet ist, wobei der Treiberchip (IC) dazu konfiguriert ist, zumindest das Datensignal und das Berührungssignal bereitzustellen,
wobei der periphere Bereich (NA) einen Fan-Out-Bereich umfasst, der Fan-Out-Bereich sich zwischen dem Anzeigebereich (AA) und dem Treiberchip (IC) befindet, der Fan-Out-Bereich einen ersten Teilbereich und einen zweiten Teilbereich umfasst, der erste Teilbereich näher am Anzeigebereich (AA) liegt als der zweite Teilbereich, und der erste Teilbereich und der zweite Teilbereich nicht miteinander überlappen;
wobei das Arraysubstrat ferner eine Vielzahl von Datensignalleitungen, die sich im Fan-Out-Bereich befinden, und eine Vielzahl von Berührungssignalleitungen (TLL), die sich im Fan-Out-Bereich befinden, umfasst, wobei Enden der Vielzahl von Datensignalleitungen elektrisch mit dem Treiberchip (IC) verbunden sind, die anderen Enden der Vielzahl von Datensignalleitungen jeweils elektrisch mit der Vielzahl von Datensignalanschlüssen (DL) verbunden sind, Enden der Vielzahl von Berührungssignalleitungen (TLL) elektrisch mit dem Treiberchip (IC) verbunden sind und die anderen Enden der Vielzahl von Berührungssignalleitungen (TLL) jeweils elektrisch mit der Vielzahl von Berührungssignalanschlüssen (TL) verbunden sind;
wobei zumindest eine der Vielzahl von Datensignalleitungen eine erste Datensignalteilleitung (DLL1), die sich im ersten Teilbereich befindet, und eine zweite Datensignalteilleitung, die sich im zweiten Teilbereich befindet, umfasst, wobei die erste Datensignalteilleitung (DLL1) elektrisch zwischen die zweite Datensignalteilleitung und einem jeweiligen Datensignalanschluss (DL) geschaltet ist; und zumindest eine der Vielzahl von Berührungssignalleitungen (TLL) eine erste Berührungssignalteilleitung (TLL1), die sich im ersten Teilbereich befindet, und eine zweite Berührungssignalteilleitung (TLL2), die sich im zweiten Teilbereich befindet, umfasst, und die erste Berührungssignalteilleitung (TLL1) elektrisch zwischen die zweite Berührungssignalteilleitung (TLL2) und einem jeweiligen Berührungssignalanschluss (TL) geschaltet ist;
wobei die Vielzahl von Datensignalanschlüssen (DL) und die Vielzahl von Berührungssignalanschlüssen (TL) sich in einer selben leitfähigen Schicht befinden;
wobei ein Teil einer Vielzahl von zweiten Datensignalteilleitungen (DLL2) sich in einer leitfähigen Schicht befindet, die von einer leitfähigen Schicht verschieden ist, in der sich der andere Teil der Vielzahl von zweiten Datensignalteilleitungen (DLL2) befindet;
wobei ein Teil der Vielzahl von zweiten Datensignalteilleitungen (DLL2) sich in einer ersten leitfähigen Schicht (20) befindet und der andere Teil der Vielzahl von zweiten Datensignalteilleitungen (DLL2) sich in einer zweiten leitfähigen Schicht (30) befindet,
**dadurch gekennzeichnet, dass** orthografische Projektionen der zweiten Datensignalteilleitungen (DLL2) in der ersten leitfähigen Schicht (20) auf dem Basissubstrat (10) sich mit orthografischen Projektionen der zweiten Datensignalteilleitungen (DLL2) in der zweiten leitfähigen Schicht (30) auf dem Basissubstrat (10) überlappen.

2. Arraysubstrat nach Anspruch 1, wobei der Fan-Out-Bereich ferner einen dritten Teilbereich umfasst und der dritte Teilbereich näher am Treiberchip (IC) liegt als der zweite Teilbereich;
zumindest eine der Vielzahl von Datensignalleitungen ferner eine dritte Datensignalteilleitung (DLL3) umfasst, die sich im dritten Teilbereich befindet, und zumindest eine der Vielzahl von Berührungssignalleitungen (TLL) ferner eine dritte Berührungssignalteilleitung (TLL3) umfasst, die sich im dritten Teilbereich befindet;
der Treiberchip (IC) eine Vielzahl von Kontaktstiften umfasst, Enden einer Vielzahl von dritten Datensignalteilleitungen (DLL3) jeweils elektrisch mit einem Teil der Vielzahl von Kontaktstiften des Treiberchips (IC) verbunden sind, und Enden einer Vielzahl von dritten Berührungssignalteilleitungen (TLL3) jeweils elektrisch mit dem anderen Teil der Vielzahl von Kontaktstiften des Treiberchips (IC) verbunden sind; und
eine Ausrichtungsreihenfolge der dritten Datensignalteilleitung (DLL3) und der dritten Berührungssignalteilleitung (TLL3) einer Ausrichtungsreihenfolge der Vielzahl von Kontaktstiften des Treiberchips (IC) entspricht.

3. Arraysubstrat nach Anspruch 1 oder 2, wobei sich jede der Vielzahl von zweiten Berührungssignalteilleitungen (TLL2) in der ersten leitfähigen Schicht (20) befindet,
wobei zumindest eine Teilleitung in einer Kombination der Vielzahl von zweiten Datensignalteilleitungen (DLL2) und der Vielzahl von zweiten Berührungssignalteilleitungen (TLL2) sich in einer leitfähigen Schicht befindet, die von einer leitfähigen Schicht verschieden ist, in der sich eine zu der zumindest einen Teilleitung benachbarte Teilleitung befindet.

4. Arraysubstrat nach Anspruch 3, wobei zumindest eine zweite Datensignalteilleitung (DLL2) und zumindest ein Datensignalanschluss (DL), die elektrisch miteinander verbunden sind, sich in verschiedenen leitfähigen Schichten befinden, und die zweite Berührungssignalteilleitung (TLL2) und der Berührungssignalanschluss (TL), die elektrisch miteinander verbunden sind, sich beide in verschiedenen leitfähigen Schichten befinden.

5. Arraysubstrat nach Anspruch 3, wobei die erste Berührungssignalteilleitung (TLL1) und der Berührungssignalanschluss (TL), die elektrisch miteinander verbunden sind, sich beide in unterschiedlichen leitfähigen Schichten befinden, und die erste Berührungssignalteilleitung (TLL1) und die zweite Berührungssignalteilleitung (TLL2), die elektrisch miteinander verbunden sind, sich beide in einer selben leitfähigen Schicht befinden.

6. Arraysubstrat nach Anspruch 5, wobei die erste Berührungssignalteilleitung (TLL1), die zweite Berührungssignalteilleitung (TLL2) und die dritte Berührungssignalteilleitung (TLL3), die elektrisch miteinander verbunden sind, sich alle in einer selben leitfähigen Schicht befinden.

7. Arraysubstrat nach Anspruch 4, wobei die Vielzahl von Datensignalanschlüssen (DL) zumindest einen Datensignalanschluss eines ersten Typs umfasst; und
für den zumindest einen Datensignalanschluss vom ersten Typ der Datensignalanschluss (DL), die erste Datensignalteilleitung (DLL1) und die zweite Datensignalteilleitung (DLL2), die elektrisch miteinander verbunden sind, sich alle in einer selben leitfähigen Schicht befinden, wobei die Vielzahl von Datensignalanschlüssen (DL) zumindest einen Datensignalanschluss vom zweiten Typ umfasst; und
für den zumindest einen Datensignalanschluss vom zweiten Typ der Datensignalanschluss (DL) und die erste Datensignalteilleitung (DLL1), die elektrisch miteinander verbunden sind, sich in einer selben leitfähigen Schicht befinden, und die erste Datensignalteilleitung (DLL1) und die zweite Datensignalteilleitung (DLL2), die elektrisch miteinander verbunden sind, sich in unterschiedlichen leitfähigen Schichten befinden.

8. Arraysubstrat nach Anspruch 7, wobei für den zumindest einen Datensignalanschluss vom ersten Typ der Datensignalanschluss (DL), die erste Datensignalteilleitung (DLL1), die zweite Datensignalteilleitung (DLL2) und die dritte Datensignalteilleitung (DLL3), die elektrisch miteinander verbunden sind, sich alle in einer selben leitfähigen Schicht befinden,
wobei für den zumindest einen Datensignalanschluss vom zweiten Typ der Datensignalanschluss (DL) und die erste Datensignalteilleitung (DLL1), die elektrisch miteinander verbunden sind, sich in derselben leitfähigen Schicht befinden, die erste Datensignalteilleitung (DLL1) und die zweite Datensignalteilleitung (DLL2), die elektrisch miteinander verbunden sind, sich in den verschiedenen leitfähigen Schichten befinden, die erste Datensignalteilleitung (DLL1) und die dritte Datensignalteilleitung (DLL3), die elektrisch miteinander verbunden sind, sich in verschiedenen leitfähigen Schichten befinden, und die zweite Datensignalteilleitung (DLL2) und die dritte Datensignalteilleitung (DLL3), die elektrisch miteinander verbunden sind, sich in einer selben leitfähigen Schicht befinden.

9. Arraysubstrat nach Anspruch 7, wobei für die erste Berührungssignalteilleitung (TLL1) und den Berührungssignalanschluss (TL), die elektrisch miteinander verbunden sind, der Berührungssignalanschluss (TL) durch ein erstes Durchkontaktierungsloch (VH1) elektrisch mit der ersten Berührungssignalteilleitung (TLL1) verbunden ist,
wobei für die erste Datensignalteilleitung (DLL1) und die zweite Datensignalteilleitung (DLL2), die sich in verschiedenen leitfähigen Schichten befinden und elektrisch miteinander verbunden sind, die erste Datensignalteilleitung (DLL1) durch ein zweites Durchkontaktierungsloch (VH2) elektrisch mit der zweiten Datensignalteilleitung (DLL2) verbunden ist,
wobei das erste Durchkontaktierungsloch (VH1) sich auf einer Seite des ersten Teilbereichs nahe dem Anzeigebereich (AA) befindet und das zweite Durchkontaktierungsloch (VH2) sich auf einer Seite des ersten Teilbereichs nahe dem zweiten Teilbereich befindet,
wobei im ersten Teilbereich eine orthografische Projektion jeder von zumindest einer ersten Berührungssignalteilleitung (TLL1) auf das Basissubstrat (10) sich nicht mit einer orthografischen Projektion einer beliebigen ersten Datensignalteilleitung (DLL1) auf das Basissubstrat (10) schneidet; und/oder
im ersten Teilbereich eine orthografische Projektion jeder von zumindest einer ersten Berührungssignalteilleitung (TLL1) auf das Basissubstrat (10) sich mit orthografischen Projektionen von zumindest zwei ersten Datensignalteilleitungen (DLL1) auf das Basissubstrat (10) schneidet,
wobei im ersten Teilbereich eine Vielzahl von Gruppen von ersten Berührungssignalteilleitungen (TTL1) periodisch ausgerichtet ist;
eine Gruppe von ersten Berührungssignalteilleitungen (TLL1) k erste Berührungssignalteilleitungen (TLL1) umfasst, wobei k eine positive ganze Zahl größer oder gleich 3 ist; und
in der Gruppe von ersten Berührungssignalteilleitungen (TLL1) eine orthografische Projektion einer 1-ten ersten Berührungssignalteilleitung auf das Basissubstrat (10) sich nicht mit der orthografischen Projektion einer beliebigen ersten Datensignalteilleitung (DLL1) auf das Basissubstrat (10) schneidet, eine orthografische Projektion jeder von 2-ten bis (k-1)-ten ersten Berührungssignalteilleitungen auf das Basissubstrat (10) sich jeweils mit den orthografischen Projektionen von zwei ersten Datensignalteilleitungen (DLL1) auf das Basissubstrat (10) schneidet, und eine orthografische Projektion einer k-ten ersten Berührungssignalteilleitung auf das Basissubstrat sich jeweils mit orthografischen Projektionen von vier ersten Datensignalteilleitungen (DLL1) auf das Basissubstrat (10) schneidet.

10. Arraysubstrat nach Anspruch 7, wobei im ersten Teilbereich zumindest ein Teil einer orthografischen Projektion jeder einer Vielzahl von ersten Berührungssignalteilleitungen (TLL1) auf das Basissubstrat (10) sich zwischen orthografischen Projektionen von zwei ersten Datensignalteilleitungen (DLL1), die elektrisch mit dem Datensignalanschluss vom ersten Typ verbunden sind, auf das Basissubstrat (10) befindet; und/oder
im ersten Teilbereich eine orthografische Projektion der ersten Datensignalteilleitung (DLL1), die elektrisch mit dem Datensignalanschluss des zweiten Typs verbunden ist, auf das Basissubstrat (10) sich zwischen orthografischen Projektionen von zwei ersten Datensignalteilleitungen (DLL1), die elektrisch mit dem Datensignalanschluss des ersten Typs verbunden sind, auf das Basissubstrat (10) befindet.

11. Arraysubstrat nach Anspruch 6, wobei im zweiten Teilbereich beliebige zwei der Vielzahl von zweiten Datensignalteilleitungen (DLL2) und der Vielzahl von zweiten Berührungssignalteilleitungen (TLL2) parallel zueinander sind,
wobei im zweiten Teilbereich für eine Kombination der Vielzahl von zweiten Datensignalteilleitungen (DLL2) und der Vielzahl von zweiten Berührungssignalteilleitungen (TLL2) eine orthografische Projektion einer in der ersten leitfähigen Schicht (20) befindlichen Teilleitung auf das Basissubstrat (10) zumindest teilweise eine orthografische Projektion von zumindest einer zu der Teilleitung benachbarten Teilleitung auf das Basissubstrat (10) überlappt,
wobei die Vielzahl von Kontaktstiften des Treiberchips (IC) einen ersten Kontaktstift, der dazu konfiguriert ist, das Datensignal bereitzustellen, und einen zweiten Kontaktstift, der dazu konfiguriert ist, das Berührungssignal bereitzustellen, umfassen;
die Vielzahl von Kontaktstiften periodisch in einer Reihenfolge von M ersten Kontaktstiften und N zweiten Kontaktstiften ausgerichtet ist, wobei M größer oder gleich 2 ist und N gleich 1 oder 2 ist; und
im dritten Teilbereich die dritte Datensignalteilleitung (DLL3) und die dritte Berührungssignalteilleitung (TLL3) periodisch in einer Reihenfolge von m dritten Datensignalteilleitungen und n dritten Berührungssignalteilleitungen ausgerichtet sind, wobei m gleich M ist und n gleich 1 ist.

12. Arraysubstrat nach einem der Ansprüche 1 bis 5, wobei die Pixeltreiberschaltung zumindest einen Dünnschichttransistor umfasst, der auf dem Basissubstrat (10) angeordnet ist, der Dünnschichttransistor eine aktive Schicht, eine Gate-Elektrode (TG), eine Source-Elektrode (TS) und eine Drain-Elektrode (TD) umfasst, und das Arraysubstrat eine Pixelelektrode (40) und eine gemeinsame Elektrode (50) umfasst; und
wobei das Arraysubstrat umfasst:
eine erste leitfähige Schicht (20), die auf dem Basissubstrat (10) angeordnet ist, wobei sich die Gate-Elektrode (TG) in der ersten leitfähigen Schicht (20) befindet;
eine aktive Schicht (ACT), die auf einer von dem Basissubstrat (10) abgewandten Seite der ersten leitfähigen Schicht (20) angeordnet ist;
eine dritte leitfähige Schicht, die auf einer von dem Basissubstrat (10) abgewandten Seite der aktiven Schicht (ACT) angeordnet ist, wobei sich die Pixelelektrode (40) in der dritten leitfähigen Schicht befindet;
eine zweite leitfähige Schicht (30), die auf einer von dem Basissubstrat (10) abgewandten Seite der dritten leitfähigen Schicht angeordnet ist, wobei sich die Source-Elektrode (TS) und die Drain-Elektrode (TD) in der zweiten leitfähigen Schicht (30) befinden; und
eine vierte leitfähige Schicht, die auf einer von dem Basissubstrat (10) abgewandten Seite der zweiten leitfähigen Schicht (30) angeordnet ist, wobei sich die gemeinsame Elektrode (50) in der vierten leitfähigen Schicht befindet, und
wobei die Vielzahl von Datensignalanschlüssen (DL) und die Vielzahl von Berührungssignalanschlüssen (TL) sich in der zweiten leitfähigen Schicht (30) befinden, die Vielzahl von Berührungssignalleitungen (TLL) sich in der ersten leitfähigen Schicht (20) befinden, die zweite Datensignalteilleitung (DLL2), die elektrisch mit einem Datensignalanschluss eines ersten Typs verbunden ist, sich in der zweiten leitfähigen Schicht (30) befindet, und die zweite Datensignalteilleitung (DLL2), die elektrisch mit einem Datensignalanschluss eines zweiten Typs verbunden ist, sich in der ersten leitfähigen Schicht (20) befindet.

13. Berührungsanzeigefeld, umfassend das Arraysubstrat nach einem der Ansprüche 1 bis 12.

14. Anzeigevorrichtung, umfassend das Arraysubstrat nach einem der Ansprüche 1 bis 12 oder das Berührungsanzeigefeld nach Anspruch 13.

15. Fahrzeugmontierter Anzeigebildschirm, umfassend das Arraysubstrat nach einem der Ansprüche 1 bis 12 oder das Berührungsanzeigefeld nach Anspruch 13.

## Revendications

1. Substrat de réseau comprenant :
un substrat de base (10) comprenant une zone d'affichage (AA) et une zone périphérique (NA) au moins situé sur au moins un côté de la zone d'affichage (AA) ;
une pluralité de cellules de pixels (P) disposées dans la zone d'affichage (AA), dans lequel la cellule de pixels comprend un circuit d'attaque de pixels ;
une pluralité d'électrodes tactiles disposées dans la zone d'affichage (AA) ;
une pluralité de lignes de signal de données (DL) au moins partiellement situées dans la zone d'affichage (AA), dans lequel la pluralité de lignes de signal de données (DL) est respectivement connectée électriquement au circuit d'attaque de pixels de la pluralité de cellules de pixels (P) et configurée pour transmettre respectivement un signal de données à la pluralité de cellules de pixels (P) ;
une pluralité de lignes de signal tactile (TL) au moins partiellement situées dans la zone d'affichage (AA), dans lequel la pluralité de lignes de signal tactile (TL) est respectivement connectée électriquement à la pluralité d'électrodes tactiles et configurées pour transmettre respectivement un signal tactile à la pluralité d'électrodes tactiles ; et
une puce de commande (IC) située dans la zone périphérique (NA), dans lequel la puce de commande (IC) est configurée pour fournir au moins le signal de données et le signal tactile,
dans lequel la zone périphérique (NA) comprend une zone de déploiement, la zone de déploiement est située entre la zone d'affichage (AA) et la puce de commande (IC), la zone de déploiement comprend une première sous-zone et une deuxième sous-zone, la première sous-zone est plus proche de la zone d'affichage (AA) que la deuxième sous-zone, et la première sous-zone et la deuxième sous-zone ne se chevauchent pas ;
dans lequel le substrat de réseau comprend en outre une pluralité de conducteurs de signal de données situés dans la zone de déploiement et une pluralité de conducteurs de signal tactile (TLL) situés dans la zone de déploiement extérieur, dans lequel des extrémités de la pluralité de conducteurs de signal de données sont connectées électriquement à la puce de commande (IC), les autres extrémités de la pluralité de conducteurs de signal de données sont connectées électriquement à la pluralité de lignes de signal de données (DL) respectivement, des extrémités de la pluralité de conducteurs de signal tactile (TLL) sont connectées électriquement à la puce de commande (IC), et les autres extrémités de la pluralité de conducteurs de signal tactile (TLL) sont connectées électriquement à la pluralité de lignes de signal tactile (TL) respectivement ;
dans lequel au moins l'un parmi la pluralité de conducteurs de signal de données comprend un premier sous-conducteur de signal de données (DLL1) situé dans la première sous-zone et un deuxième sous-conducteur de signal de données situé dans la deuxième sous-zone, le premier sous-conducteur de signal de données (DLL1) est connecté électriquement entre le deuxième sous-conducteur de signal de données et une ligne de signal de données (DL) respective ; et au moins l'un parmi la pluralité de conducteurs de signal tactile (TLL) comprend un premier sous-conducteur de signal tactile (TLL1) situé dans la première sous-zone et un deuxième sous-conducteur de signal tactile (TLL2) situé dans la deuxième sous-zone, et le premier sous-conducteur de signal tactile (TLL1) est connecté électriquement entre le deuxième sous-conducteur de signal tactile (TLL2) et une ligne de signal tactile (TL) respective ;
dans lequel la pluralité de lignes de signal de données (DL) et la pluralité de lignes de signal tactile (TL) sont situées dans une même couche conductrice ;
dans lequel une partie d'une pluralité de deuxièmes sous-conducteurs de signal de données (DLL2) est située dans une couche conductrice différente d'une couche conductrice où l'autre partie de la pluralité de seconds sous-conducteurs de signal de données (DLL2) est située ;
dans lequel une partie de la pluralité de deuxièmes sous-conducteurs de signal de données (DLL2) est située dans une première couche conductrice (20), et l'autre partie de la pluralité de deuxièmes sous-conducteurs de signal de données (DLL2) est située dans une deuxième couche conductrice (30),
**caractérisé en ce que** des projections orthographiques des deuxièmes sous-conducteurs de signal de données (DLL2) dans la première couche conductrice (20) sur le substrat de base (10) chevauchent des projections orthographiques des deuxièmes sous-conducteurs de signal de données (DLL2) dans la seconde couche conductrice (30) sur le substrat de base (10).

2. Substrat de réseau selon la revendication 1, dans lequel la zone de déploiement comprend en outre une troisième sous-zone, et la troisième sous-zone est plus proche de la puce de commande (IC) que la deuxième sous-zone ;
au moins l'un parmi la pluralité de conducteurs de signal de données comprend en outre un troisième sous-conducteur de signal de données (DLL3) situé dans la troisième sous-zone, et au moins l'un parmi la pluralité de conducteurs de signal tactile (TLL) comprend en outre un troisième sous-conducteur de signal tactile (TLL3) situé dans la troisième sous-zone ;
la puce de commande (IC) comprend une pluralité de broches de contact, les extrémités d'une pluralité de troisièmes sous-conducteurs de signal de données (DLL3) sont respectivement connectées électriquement à une partie de la pluralité de broches de contact de la puce de commande (IC), et les extrémités d'une pluralité de troisièmes sous-conducteurs de signal tactile (TLL3) sont respectivement connectées électriquement à l'autre partie de la pluralité de broches de contact de la puce de commande (IC) ; et
un ordre d'agencement du troisième sous-conducteur de signal de données (DLL3) et du troisième sous-conducteur de signal tactile (TLL3) correspond à un ordre d'agencement de la pluralité de broches de contact de la puce de commande (IC).

3. Substrat de réseau selon la revendication 1 ou 2, dans lequel chacun parmi la pluralité de deuxièmes sous-conducteurs de signal tactile (TLL2) est situé dans la première couche conductrice (20),
dans lequel au moins un sous-conducteur dans une combinaison de la pluralité de deuxièmes sous-conducteurs de signal de données (DLL2) et de la pluralité de deuxièmes sous-conducteurs de signal tactile (TLL2) est situé dans une couche conductrice différente d'une couche conductrice où un sous-conducteur adjacent à l'au moins un sous-conducteur est situé.

4. Substrat de réseau selon la revendication 3, dans lequel au moins un deuxième sous-conducteur de signal de données (DLL2) et au moins une ligne de signal de données (DL) qui sont connectés électriquement l'un à l'autre sont situés dans des couches conductrices différentes, et le deuxième sous-conducteur de signal tactile (TLL2) et la ligne de signal tactile (TL) qui sont connectés électriquement l'un à l'autre sont tous deux situés dans des couches conductrices différentes.

5. Substrat de réseau selon la revendication 3, dans lequel le premier sous-conducteur de signal tactile (TLL1) et la ligne de signal tactile (TL) qui sont connectés électriquement l'un à l'autre sont tous deux situés dans des couches conductrices différentes, et le premier sous-conducteur de signal tactile (TLL1) et le deuxième sous-conducteur de signal tactile (TLL2) qui sont connectés électriquement l'un à l'autre sont tous deux situés dans une même couche conductrice.

6. Substrat de réseau selon la revendication 5, dans lequel le premier sous-conducteur de signal tactile (TLL1), le deuxième sous-conducteur de signal tactile (TLL2) et le troisième sous-conducteur de signal tactile (TLL3) qui sont connectés électriquement l'un à l'autre sont tous situés dans une même couche conductrice.

7. Substrat de réseau selon la revendication 4, dans lequel la pluralité de lignes de signal de données (DL) comprend au moins une ligne de signal de données de premier type ; et
pour l'au moins une ligne de signal de données de premier type, la ligne de signal de données (DL), le premier sous-conducteur de signal de données (DLL1) et le deuxième sous-conducteur de signal de données (DLL2) qui sont connectés électriquement l'un à l'autre sont tous situés dans une même couche conductrice, dans lequel la pluralité de lignes de signal de données (DL) comprend au moins une ligne de signal de données de second type ; et
pour l'au moins une ligne de signal de données de deuxième type, la ligne de signal de données (DL) et le premier sous-conducteur de signal de données (DLL1) qui sont connectés électriquement l'un à l'autre sont situés dans une même couche conductrice, et le premier sous-conducteur de signal de données (DLL1) et le deuxième sous-conducteur de signal de données (DLL2) qui sont connectés électriquement l'un à l'autre sont situés dans des couches conductrices différentes.

8. Substrat de réseau selon la revendication 7, dans lequel pour l'au moins une ligne de signal de données de premier type, la ligne de signal de données (DL), le premier sous-conducteur de signal de données (DLL1), le deuxième sous-conducteur de signal de données (DLL2) et le troisième sous-conducteur de signal de données (DLL3) qui sont connectés électriquement l'un à l'autre sont tous situés dans une même couche conductrice,
dans lequel pour l'au moins une ligne de signal de données de second type, la ligne de signal de données (DL) et le premier sous-conducteur de signal de données (DLL1) qui sont connectés électriquement l'un à l'autre sont situés dans la même couche conductrice, le premier sous-conducteur de signal de données (DLL1) et le deuxième sous-conducteur de signal de données (DLL2) qui sont connectés électriquement l'un à l'autre sont situés dans les différentes couches conductrices, le premier sous-conducteur de signal de données (DLL1) et le troisième sous-conducteur de signal de données (DLL3) qui sont connectés électriquement l'un à l'autre sont situés dans des couches conductrices différentes, et le deuxième sous-conducteur de signal de données (DLL2) et le troisième sous-conducteur de signal de données (DLL3) qui sont connectés électriquement l'un à l'autre sont situés dans une même couche conductrice.

9. Substrat de réseau selon la revendication 7, dans lequel pour le premier sous-conducteur de signal tactile (TLL1) et la ligne de signal tactile (TL) qui sont connectés électriquement l'un à l'autre, la ligne de signal tactile (TL) est connectée électriquement au premier sous-conducteur de signal tactile (TLL1) par un premier trou d'interconnexion (VH1),
dans lequel pour le premier sous-conducteur de signal de données (DLL1) et le deuxième sous-conducteur de signal de données (DLL2) qui sont situés dans des couches conductrices différentes et connectés électriquement l'un à l'autre, le premier sous-conducteur de signal de données (DLL1) est connecté électriquement au deuxième sous-conducteur de signal de données (DLL2) par le biais d'un second trou d'interconnexion (VH2),
dans lequel le premier trou d'interconnexion (VH1) est situé au niveau d'un côté de la première sous-zone proche de la zone d'affichage (AA), et le second trou d'interconnexion (VH2) est situé au niveau d'un côté de la première sous-zone proche de la deuxième sous-zone,
dans lequel dans la première sous-zone, une projection orthographique de chacun d'au moins un premier sous-conducteur de signal tactile (TLL1) sur le substrat de base (10) ne croise pas une projection orthographique de l'un quelconque premier sous-conducteur de signal de données (DLL1) sur le substrat de base (10) ; et/ou
dans la première sous-zone, une projection orthographique de chacun d'au moins un premier sous-conducteur de signal tactile (TLL1) sur le substrat de base (10) croise des projections orthographiques d'au moins deux premiers sous-conducteurs de signal de données (DLL1) sur le substrat de base (10),
dans lequel dans la première sous-zone, une pluralité de groupes de premiers sous-conducteurs de signal tactile (TTL1) est agencée périodiquement ;
un groupe de premiers sous-conducteurs de signal tactile (TLL1) comprend k premiers sous-conducteurs de signal tactile (TLL1), où k est un nombre entier positif supérieur ou égal à 3 ; et
dans le groupe des premiers sous-conducteurs de signal tactile (TLL1), une projection orthographique d'un 1^{er} premier sous-conducteur de signal tactile sur le substrat de base (10) ne croise pas la projection orthographique de l'un quelconque premier sous-conducteur de signal de données (DLL1) sur le substrat de base (10), une projection orthographique de chacun des 2^{e} à (k-1)^{ième} premiers sous-conducteurs de signal tactile sur le substrat de base (10) croise respectivement les projections orthographiques de deux premiers sous-conducteurs de signal de données (DLL1) sur le substrat de base (10), et une projection orthographique d'un k^{ième} premier sous-conducteur de signal tactile sur le substrat de base croise respectivement les projections orthographiques de quatre premiers sous-conducteurs de signal de données (DLL1) sur le substrat de base (10).

10. Substrat de réseau selon la revendication 7, dans lequel, dans la première sous-zone, au moins une partie d'une projection orthographique de chacun d'une pluralité de premiers sous-conducteurs de signal tactile (TLL1) sur le substrat de base (10) est située entre des projections orthographiques de deux premiers sous-conducteurs de signal de données (DLL1) connectés électriquement à la ligne de signal de données de premier type sur le substrat de base (10) ; et/ou
dans la première sous-zone, une projection orthographique du premier sous-conducteur de signal de données (DLL1) connecté électriquement à la ligne de signal de données de second type sur le substrat de base (10) est située entre des projections orthographiques de deux premiers sous-conducteurs de signal de données (DLL1) connectés électriquement à la ligne de signal de données de premier type sur le substrat de base (10).

11. Substrat de réseau selon la revendication 6, dans lequel, dans la deuxième sous-zone, deux quelconques de la pluralité de deuxièmes sous-conducteurs de signal de données (DLL2) et de la pluralité de deuxièmes sous-conducteurs de signal tactile (TLL2) sont parallèles l'un à l'autre,
dans lequel dans la deuxième sous-zone, pour une combinaison de la pluralité de seconds sous-conducteurs de signal de données (DLL2) et de la pluralité de seconds sous-conducteurs de signal tactile (TLL2), une projection orthographique d'un sous-conducteur situé dans la première couche conductrice (20) sur le substrat de base (10) chevauche au moins partiellement une projection orthographique d'au moins un sous-conducteur adjacent au sous-conducteur sur le substrat de base (10),
dans lequel la pluralité de broches de contact de la puce de commande (IC) comprend une première broche de contact configurée pour fournir le signal de données et une seconde broche de contact configurée pour fournir le signal tactile ;
la pluralité de broches de contact sont périodiquement agencées dans un ordre de M premières broches de contact et N secondes broches de contact, où M est supérieur ou égal à 2, et N est égal à 1 ou 2 ; et
dans la troisième sous-zone, le troisième sous-conducteur de signal de données (DLL3) et le troisième sous-conducteur de signal tactile (TLL3) sont périodiquement agencés dans un ordre de m troisièmes sous-conducteurs de signal de données et n troisièmes sous-conducteurs de signal tactile, où m est égal à M, et n est égal à 1.

12. Substrat de réseau selon l'une quelconque des revendications 1 à 5, dans lequel le circuit d'attaque de pixels comprend au moins un transistor à couches minces disposé sur le substrat de base (10), le transistor à couches minces comprend une couche active, une électrode de grille (TG), une électrode de source (TS) et une électrode de drain (TD), et le substrat de réseau comprend une électrode de pixel (40) et une électrode commune (50) ; et
dans lequel le substrat de réseau comprend :
une première couche conductrice (20) disposée sur le substrat de base (10), dans lequel l'électrode de grille (TG) est située dans la première couche conductrice (20) ;
une couche active (ACT) disposée sur un côté de la première couche conductrice (20) éloigné du substrat de base (10) ;
une troisième couche conductrice disposée sur un côté de la couche active (ACT) éloigné du substrat de base (10), dans lequel l'électrode de pixel (40) est située dans la troisième couche conductrice ;
une deuxième couche conductrice (30) disposée sur un côté de la troisième couche conductrice éloigné du substrat de base (10), dans lequel l'électrode de source (TS) et l'électrode de drain (TD) sont situées dans la deuxième couche conductrice (30) ; et
une quatrième couche conductrice disposée sur un côté de la deuxième couche conductrice (30) éloigné du substrat de base (10), dans lequel l'électrode commune (50) est située dans la quatrième couche conductrice, et
dans lequel la pluralité de lignes de signal de données (DL) et la pluralité de lignes de signal tactile (TL) sont situées dans la deuxième couche conductrice (30), la pluralité de conducteurs de signal tactile (TLL) est située dans la première couche conductrice (20), le deuxième sous-conducteur de signal de données (DLL2) connecté électriquement à une ligne de signal de données de premier type est situé dans la deuxième couche conductrice (30), et le deuxième sous-conducteur de signal de données (DLL2) connecté électriquement à une ligne de signal de données de second type est situé dans le premier couche conductrice (20).

13. Panneau d'affichage tactile comprenant le substrat de réseau selon l'une quelconque des revendications 1 à 12.

14. Dispositif d'affichage comprenant le substrat de réseau selon l'une quelconque des revendications 1 à 12 ou le panneau d'affichage tactile selon la revendication 13.

15. Écran d'affichage monté sur véhicule comprenant le substrat de réseau selon l'une quelconque des revendications 1 à 12 ou l'écran d'affichage tactile selon la revendication 13.
